# EUROPEAN PATENT APPLICATION

(11) **EP 4 607 797 A2**
(43) Date of publication of application: **27.08.2025**
(21) Application number: 24205712.3
(22) Date of filing: 09.10.2024
(51) Int. Cl.: H03K 17/12

(54) **SEMICONDUCTOR DEVICE**

(30) Priority: 20.02.2024 KR 20240024570
(71) Applicant: Samsung Electronics Co., Ltd, Suwon-si, Gyeonggi-do 16677 (KR)
(72) Inventor: HWANG, In Jun, Suwon-si (KR)
(74) Representative: Marks & Clerk LLP

(57) **Abstract**

A semiconductor device may include: a plurality of unit blocks comprising switching circuits, each of the switching circuits including: a high electron mobility transistor; and an amplification circuit configured to apply a gate signal to a gate electrode of the high electron mobility transistor. The semiconductor device further includes a signal generator configured to provide a pull-up signal and a pull-down signal to the amplification circuit of each of the switching circuits. The high electron mobility transistors of the switching circuits are connected in parallel.

## Description

### BACKGROUND

### 1. Field

The present disclosure relates to a semiconductor device.

### 2. Description of the Related Art

In modern society, semiconductor devices support people's daily lives. In particular, the importance of electric power semiconductor devices used in various fields such as transportation such as electric vehicles, railways, and electric trams, renewable energy systems such as solar power generation and wind power generation, and mobile devices is gradually increasing. An electric power semiconductor device or system is a semiconductor device used to handle high voltage or high current, and performs functions such as electric power conversion and control in large electric power systems or high power electronic devices. The electric power semiconductor device has an ability to handle high electric power and durability, so it can handle large amounts of current and endure high voltages. For example, an electric power semiconductor device may handle voltages of hundreds to thousands of volts and currents of tens of amperes to thousands of amperes. The electric power semiconductor device may minimize power loss to improve the efficiency of electrical energy. Additionally, electric power semiconductor device may be operated stably even in a high temperature environment.

These electric power semiconductor devices may be classified according to material, and, for example, may include an SiC electric power semiconductor device and a GaN electric power semiconductor device. By manufacturing an electric power semiconductor device using SiC or GaN instead of conventional silicon wafers (Si wafers), the drawbacks of silicon (which has unstable characteristics at high temperatures) may be compensated. The SiC electric power semiconductor device is resistant to high temperatures and has low power loss, and may be suitable for electric vehicles, renewable energy systems, etc. The GaN electric power semiconductor device has high costs, but it is efficient in terms of speed and suitable for high-speed charging of mobile devices.

### SUMMARY

The present disclosure attempts to provide a semiconductor device including a high electron mobility transistor capable of improving reliability.

According to one or more example embodiments, a semiconductor device may include: a plurality of unit blocks comprising switching circuits, each of the switching circuits including: a high electron mobility transistor; and an amplification circuit configured to apply a gate signal to a gate electrode of the high electron mobility transistor. The semiconductor device further includes a signal generator configured to provide a pull-up signal and a pull-down signal to the amplification circuit of each of the switching circuits. The high electron mobility transistors of the switching circuits are connected in parallel.

According to one or more example embodiments, a semiconductor device may include: a plurality of high electron mobility transistors arranged in a first direction; and a plurality of amplification circuits disposed apart from the plurality of high electron mobility transistors in a second direction intersecting the first direction, each including a first transistor, a second transistor, and a capacitor arranged in the first direction. Each of the high electron mobility transistors may include: a channel layer; a barrier layer disposed on the channel layer; a gate electrode disposed on the barrier layer; and a source electrode and a drain electrode connected to the channel layer and disposed on opposite sides of the gate electrode. The first transistor may include: a first channel layer; a first barrier layer disposed on the first channel layer; a first gate electrode disposed on the first barrier layer; and a first source electrode and a first drain electrode connected to the first channel layer and disposed on opposite sides of the first gate electrode. The second transistor may include: a second channel layer; a second barrier layer disposed on the second channel layer; a second gate electrode disposed on the second barrier layer; and a second source electrode and a second drain electrode connected to the second channel layer and disposed on opposite sides of the second gate electrode.

According to one or more example embodiments, a semiconductor device may include: a substrate; a plurality of high electron mobility transistors disposed on the substrate, and arranged in a first direction; and a plurality of amplification circuits disposed on the substrate, spaced apart from the plurality of high electron mobility transistors in a second direction intersecting the first direction, and respectively including a first transistor, a second transistor, and a capacitor arranged in the first direction. Each of the plurality of high electron mobility transistors may include: a channel layer; a barrier layer disposed on the channel layer; a gate electrode disposed on the barrier layer; a gate semiconductor layer disposed between the barrier layer and the gate electrode; and a source electrode and a drain electrode connected to the channel layer and disposed on opposite sides of the gate electrode. The first transistor may include: a first channel layer; a first barrier layer disposed on the first channel layer; a first gate electrode disposed on the first barrier layer; a first gate semiconductor layer disposed between the first barrier layer and the first gate electrode; and a first source electrode and a first drain electrode connected to the first channel layer and disposed on opposite sides of the first gate electrode. The second transistor may include: a second channel layer; a second barrier layer disposed on the second channel layer; a second gate electrode disposed on the second barrier layer; a second gate semiconductor layer disposed between the second barrier layer and the second gate electrode; and a second source electrode and a second drain electrode connected to the second channel layer and disposed on opposite sides of the second gate electrode.

According to one or more example embodiments, a semiconductor device may include: a first high electron mobility transistor; a first amplifier configured to apply a first gate signal to a first gate electrode of the first high electron mobility transistor; a second high electron mobility transistor connected in parallel with the first high electron mobility transistor; a second amplifier configured to apply a second gate signal to a second gate electrode of the second high electron mobility transistor; and a signal generator configured to provide a pull-up signal and a pull-down signal to the first amplifier and the second amplifier.

A semiconductor device according to embodiments may include high electron mobility transistors and amplification circuits connected to each of them. According to embodiments, the influence of parasitic inductance depending on the positions of each high electron mobility transistor in a semiconductor device may be minimized, and thus, the reliability of the switching operation of the high electron mobility transistor can be improved. The relative positions of a high electron mobility transistor to an associated amplification circuits may be substantially similar across the transistor/circuit pairs thereby minimizing differences in gate resistance and/or parasitic inductance. This may improve the reliability of the switching operation of the high electron mobility transistors.

At least some of the above and other features of the disclosure are set out in the claims.

### BRIEF DESCRIPTION OF THE DRAWINGS

Embodiments will be more clearly understood from the following detailed description taken in conjunction with the accompanying drawings in which:
FIG. 1 is a block diagram schematically showing an electric power semiconductor system according to one or more embodiments;
FIG. 2 is a block diagram illustrating a gate driver and a semiconductor device according to one or more embodiments;
FIG. 3 is a block diagram illustrating the configuration and operation of a semiconductor device according to one or more embodiments;
FIG. 4 is a circuit diagram of an amplification circuit according to one or more embodiments;
FIG. 5 is a circuit diagram of an amplification circuit according to one or more embodiments;
FIG. 6 is a block diagram of an electric power semiconductor system according to one or more embodiments;
FIG. 7 is a top plan view illustrating a semiconductor device according to one or more embodiments;
FIG. 8 is an enlarged view of a region A in FIG. 7;
FIG. 9 is a cross-sectional view along the line I1-I1' in FIG. 8;
FIG. 10 is a cross-sectional view along the I2-I2' line in FIG. 8;
FIG. 11 is a cross-sectional view along the I3-I3' line in FIG. 8;
FIG. 12 is a cross-sectional view along the I42-I4' line in FIG. 8;
FIG. 13 is a cross-sectional view along the I5-I5' line in FIG. 8;
FIG. 14 shows a sub-capacitor included in an amplification circuit according to one or more embodiments;
FIG. 15 is a top plan view of a semiconductor device according to one or more embodiments;
FIG. 16 is a top plan view of a semiconductor device according to one or more embodiments;
FIG. 17 is a top plan view of a semiconductor device according to one or more embodiments;
FIG. 18 is a top plan view of a semiconductor device according to one or more embodiments;
FIG. 19 is a top plan view of a semiconductor device according to one or more embodiments;
FIG. 20 is a top plan view of a semiconductor device according to one or more embodiments;
FIG. 21 is a top plan view of a semiconductor device according to one or more embodiments;
FIG. 22 is a top plan view of a semiconductor device according to one or more embodiments;
FIG. 23 is a top plan view of a semiconductor device according to one or more embodiments;
FIG. 24 is a top plan view of a semiconductor device according to one or more embodiments;
FIG. 25 is a top plan view of a semiconductor device according to one or more embodiments;
FIG. 26 is a top plan view of a semiconductor device according to one or more embodiments;
FIG. 27 is a top plan view of a semiconductor device according to one or more embodiments; and
FIG. 28 is a top plan view of a semiconductor device according to one or more embodiments.

### DETAILED DESCRIPTION

Hereinafter, with reference to accompanying drawings, various embodiments of the present disclosure will be described in detail so that a person of an ordinary skill can easily implement the present disclosure. The present disclosure may be implemented in many different forms and is not limited to the embodiments described herein.

In order to clearly describe the present disclosure, parts that are not relevant to the description are omitted, and identical or similar components are assigned the same reference numerals throughout the specification.

In addition, the size and thickness of each component shown in the drawings are shown arbitrarily for convenience of explanation, so the present disclosure is not necessarily limited to what is shown. In the drawings, the thicknesses are exaggerated for clearly expressing various layers and regions. And in the drawings, for convenience of explanation, the thicknesses of some layers and regions are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. In addition, being "on" or "above" a reference element means being positioned on or below the reference element, and does not necessarily mean being positioned "above" or "on" in a direction opposite to gravity.

In addition, unless explicitly described to the contrary, the word "comprise", and variations such as "comprises" or "comprising", will be understood to imply the inclusion of stated elements but not the exclusion of any other elements.

In addition, throughout the specification, when referring to "a plane view", it means that the target portion is viewed from above, and when referring to "a cross-section view", it means that a cross section of the target portion cut vertically is viewed from a side.

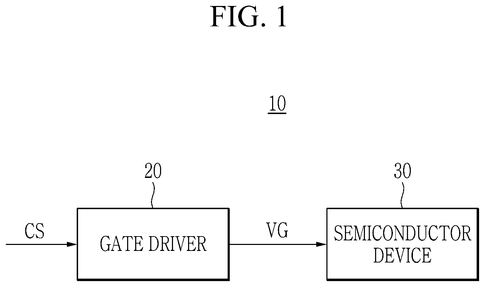

FIG. 1 is a block diagram schematically illustrating an electric power semiconductor system according to one or more embodiments.

Referring to FIG. 1, electric power semiconductor system 10 may include a gate driver 20 and a semiconductor device 30.

Referring to FIG. 1, the electric power semiconductor system 10 is a system that requires electric power, and may include, for example, transportation such as electric vehicles, railways, electric trams, renewable energy systems such as solar power generation and wind power generation, mobile devices, or household electronics, etc. In one or more embodiments, the electric power semiconductor system 10 may include a semiconductor device 30 and a gate driver 20 providing an electrical signal to the semiconductor device 30.

The gate driver 20 may receive a control signal CS from outside. The gate driver 20 may generate a gate signal VG based on the control signal CS and supply the gate signal VG to the semiconductor device 30. The control signal CS may be a signal for controlling gate driver 20. The control signal CS may be a signal output from a control unit positioned outside the electric power semiconductor system 10. For example, a control signal CS may be a signal output from a microprocessor such as a central processing unit (CPU) chip, a graphic processing unit (GPU) chip, or an application processor (AP). Unlike shown in FIG. 1, the control signal CS may be output from an integrated circuit (IC) included in the electric power semiconductor system 10. In one or more embodiments, the control signal CS may include a pulse width modulation (PWM) signal. In one or more embodiments, the gate driver 20 may generate a gate signal VG having a target magnitude or waveform based on information included in the control signal CS to output outside. Information included in the control signal CS may be, for example, the duty ratio of the PWM signal.

The gate signal VG may be a signal for controlling discrete semiconductor devices included in the semiconductor device 30. Specifically, the gate signal VG may be an electric signal provided to a terminal of a discrete semiconductor device included in the semiconductor device 30. For example, a gate signal VG may be the voltage (or current) provided to a gate electrode of a discrete semiconductor device. In one or more embodiments, the gate signal VG may have a value greater than the control signal CS. The gate driver 20 may convert an electrical signal received from outside into an appropriate signal for controlling a discrete semiconductor device included in the semiconductor device 30 to provide the converted signals to the semiconductor device 30. In one or more embodiments, the gate driver 20 may operate as a current amplifier to process fast on/off switching of a discrete semiconductor device included in semiconductor device 30.

The semiconductor device 30 may include at least one or more components for converting, controlling, or distributing electric power. As an example, the semiconductor device 30 may include components such as an inverter, a converter, a power management IC (PMIC) or a power distribution unit (PDU). Components included in the semiconductor device 30 (e.g., inverter, converter, PMIC, PDU) may include various discrete semiconductor devices inside to perform a function of converting, controlling or distributing electric power. For example, the semiconductor device 30 may include discrete semiconductor devices such as a diode, or a thyristor, or a transistor such as an IGBT or MOSFET.

In one or more embodiments, the semiconductor device 30 may include a discrete semiconductor device performing switching operations. That is, the semiconductor device 30 according to one or more embodiments may include a discrete semiconductor device performing on/off operations based on the gate signal VG, and may control or convert the supplied electric power by controlling on/off operations of the discrete semiconductor device.

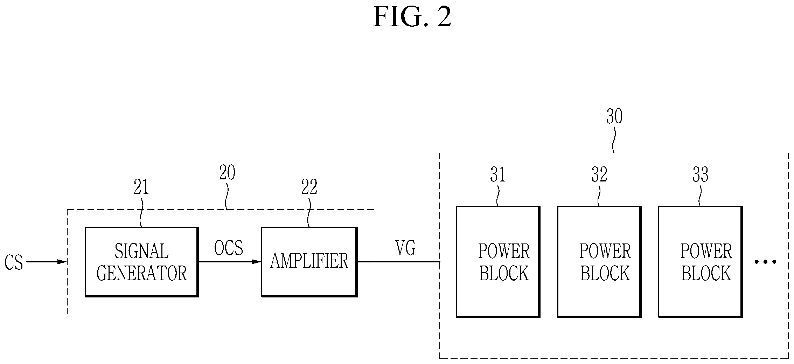

FIG. 2 is a block diagram illustrating a gate driver and a semiconductor device.

Referring to FIG. 2, the gate driver 20 may include a signal generator 21 and an amplifier 22, and the semiconductor device 30 may include unit blocks 31, 32, and 33. The unit block may be a discrete semiconductor device performing a unit function, or may be a set of discrete semiconductor devices or passive elements configured to perform a unit function.

The signal generator 21 may generate an output control signal OCS based on a control signal CS received from outside. The output control signal OCS may be a signal for controlling the output of the gate signal VG output from amplifier 22. The signal generator 21 may generate an output control signal OCS based on the control signal CS and then provide the output control signal OCS to the amplifier 22.

The amplifier 22 may output the gate signal VG to outside, or may stop output of the gate signal VG, according to the output control signal OCS received from the signal generator 21. An amplifier 22 according to the embodiment may amplify current. For example, since a signal output directly from an external microprocessor or an internal IC, such as the control signal CS shown in FIG. 2, has relatively small electric power, it may not be sufficient to drive a high electric power device such as an electric power semiconductor device. The gate driver 20 according to one or more embodiments may receive a control signal CS which is a low electric power input signal, and then output a gate signal VG with high electric power to the outside through the amplifier 22 based on the control signal CS.

The unit blocks 31, 32, and 33 may be a discrete semiconductor device performing a unit function, or may be a set of discrete semiconductor devices or passive elements configured to perform a unit function. A unit function may be, for example, a switching operation or a rectification operation. However, the function performed by each unit 31, 32, and 33 is not limited to switching and rectification. That is, each of the unit blocks 31, 32, and 33 may be designed to perform not only switching operations and rectification operations, but also various operations performed by various known discrete semiconductor devices. Unit blocks 31, 32, and 33 are included in the semiconductor device 30, and may perform functions of converting and controlling electric power such as an inverter, converter, and PMIC, together with other unit blocks 31, 32, and 33 in the semiconductor device 30.

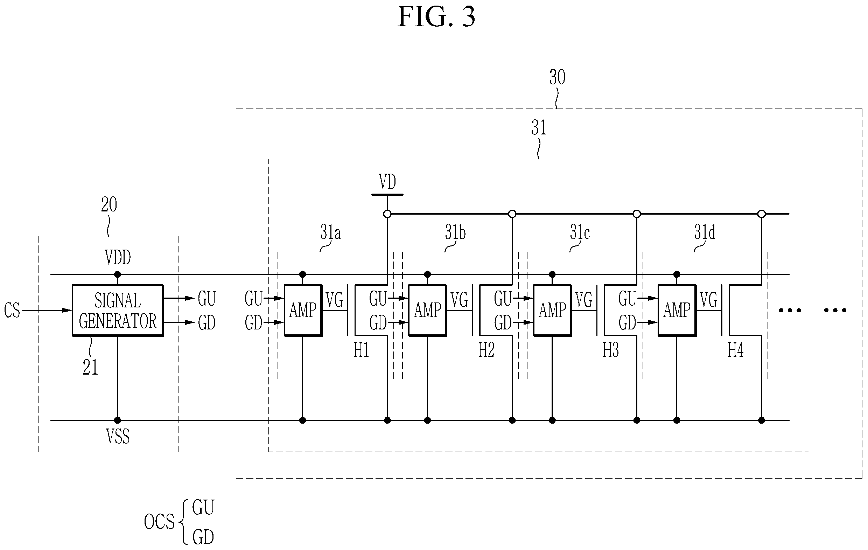

FIG. 3 is a block diagram illustrating the configuration and operation of an electric power semiconductor system according to one or more embodiments. Referring to FIG. 3, the electric power semiconductor system according to one or more embodiments may include a gate driver 20 and a semiconductor device 30.

The gate driver 20 according to the embodiment may include a signal generator 21. The gate driver 20 according to one or more embodiments may not include a part of the amplifier 22 described with reference to FIG. 2 inside. The gate driver 20 may not include the amplifier 22 described with reference to Figure 2. In one or more embodiments, the signal generator 21 may output an output control signal OCS to outside based on a control signal CS received from outside. The output control signal OCS may include a pull-up signal GU and a pull-down signal GD.

Referring to FIG. 3, the signal generator 21 may be connected to the first power voltage VDD and the second power voltage VSS. In one or more embodiments, the first power supply voltage VDD and the second power supply voltage VSS may be supplied from voltage sources. In one or more embodiments, the first power supply voltage VDD may have a voltage level of approximately 5V. In one or more embodiments, the second power supply voltage VSS may have a voltage level lower than the first power supply voltage VDD. For example, the second supply voltage VSS may be connected to ground. However, not limited thereto, the second power voltage VSS may have a negative voltage level, or may have a positive voltage level lower than the first power voltage VDD.

The signal generator 21 may receive the first power voltage VDD and second power voltage VSS, generate a pull-up signal GU and a pull-down signal GD based on the control signal CS, and output the pull-up signal GU and the pull-down signal GD to semiconductor device 30. The pull-up signal GU and pull-down signal GD may be signals for controlling the output of an amplification circuit AMP which will be described later. The pull-up signal GU and pull-down signal GD may be complementary. For example, when the pull-up signal GU is a first level, the pull-down signal GD may have a second level different from the first level. When the pull-up signal GU is the second level, the pull-down signal GD may have the first level. In one or more embodiments, the first level may be greater than the second level. For example, the first level may be approximately 5V to 6V. For example, the second level may be 0V. In one or more embodiments, a first level of the pull-up signal may be greater than a first level of the pull-down signal. For example, the first level of a pull-up signal may be approximately 5V to 10V, and the first level of a pull-down signal may be approximately 5V to 6V. In one or more embodiments, when a pull-up signal GU of the first level of and a pull-down signal GD of the second level are applied to the amplification circuit AMP, the amplification circuit AMP may output a gate signal VG of a level that turns on the plurality of high electron mobility transistors H1 to H4 (first to fourth high electron mobility transistors). When a pull-down signal GD of the first level and a pull-up signal GU of the second level are applied to the amplification circuit AMP, the amplification circuit AMP may output a gate signal VG of a level that turns off the plurality of high electron mobility transistors H1 to H4. In one or more embodiments, a pull-up signal GU may be provided simultaneously to all amplification circuits AMP included in the first unit block 31. In one or more embodiments, a pull-down signal GD may be provided simultaneously to all amplification circuits AMP included in the first unit block 31.

The semiconductor device 30 may include a first unit block 31. In FIG. 3, only the first unit block 31 is shown, but the number of unit blocks included in the semiconductor device 30 is not limited. Referring to FIG. 3, the first unit block 31 may include a plurality of switching circuits 31a to 31d. Each of the switching circuits 31a to 31d may include a high electron mobility transistor H1 to H4 and an amplification circuit AMP connected to a gate electrode of the high electron mobility transistor H1 to H4, respectively. The amplification circuit AMP may perform a similar function as amplifier 22 described with reference to FIG. 2.

The plurality of high electron mobility transistors H1 to H4 included in the first unit block 31 may be coupled in parallel with each other. That is to say, the high electron mobility transistors H1 to H4 may be connected to a first common node at a first end, and a second common node at a second end. Referring to FIG. 3, the drain electrode of each of the high electron mobility transistors H1 to H4 may be commonly connected to the third power supply voltage VD, and each source electrode may be commonly connected to the second power voltage VSS. The third power voltage VD may have a voltage level higher than the first power voltage VDD and the second power voltage VSS. For example, the third power voltage VD may have a voltage level of approximately 40V to 1000V.

The plurality of amplification circuits AMP included in the first unit block 31 may be coupled in parallel with each other. Referring to FIG. 3, a drain electrode of each of the plurality of amplification circuit AMP included in the first unit block 31 may be commonly connected to the first power voltage VDD, and each source electrode may be commonly connected to the second power voltage VSS. When a pull-up signal GU is applied to the plurality of amplification circuits AMP, each of the plurality of amplification circuits AMP may output a gate signal VG. The gate signal VG may be a voltage signal having a level higher than a threshold voltage of high electron mobility transistors H1 to H4. When a pull-down signal GD is applied to the plurality of amplification circuits AMP, each of the plurality of amplification circuits AMP may output a gate signal VG having a level of the second power voltage VSS. At this time, the gate electrode of each high electron mobility transistor H1 to H4 may be connected to the second power voltage VSS.

In one or more embodiments, the plurality of high electron mobility transistors H1 to H4 included in the first unit block 31 may operate as a single switching element. In other words, the plurality of high electron mobility transistors H1 to H4 included in the first unit block 31 may be simultaneously turned on or simultaneously turned off.

Specifically, in the case of turn-on operation, pull-up signal GU of the first level and pull-down signal GD of the second level may be simultaneously provided from the signal generator 21 to all amplification circuits AMP included in the first unit block. In response to the pull-up signal GU and the pull-down signal GD, the amplification circuit AMPs included in the first unit block may simultaneously provide the gate signal VG to each gate electrode of the plurality of the electron mobility transistor H1 to H4 included in the first unit block 31. At this time, the plurality of high electron mobility transistors H1 to H4 included in the first unit block 31 may be simultaneously turned on, and thus, currents may flow from the third power voltage VD to the second power voltage VSS via each drain electrode and source electrode of the plurality of high electron mobility transistors H1 to H4.

In the case of turn-off operation, a pull-down signal GD of the first level and a pull-up signal GU of the second level may be simultaneously provided from the signal generator 21 to all amplification circuits AMP included in the first unit block. The amplification circuits AMP included in the first unit block may stop outputting the gate signal VG, in response to the pull-down signal GD and pull-up signal GU. At this time, the voltage charged at each gate electrode of the plurality of high electron mobility transistors H1 to H4 included in the first unit block 31 may be discharged to outside through the second power voltage VSS. In this case, the plurality of high electron mobility transistors H1 to H4 included in the first unit block 31 may be simultaneously turned off, and thus, the currents that flowed via the drain electrode and source electrode of each of the plurality of high electron mobility transistors H1 to H4 may be cut off simultaneously.

In the case of the electric power semiconductor system described with reference to FIG. 2, the amplifier 22 may be positioned inside the gate driver 20, and the gate signal VG output from one amplifier 22 may be provided to all electrodes of the discrete semiconductor device included in each unit block. According to the electric power semiconductor system described with reference to FIG. 2, the distances from the amplifiers 22 to the gate electrodes of the discrete semiconductor devices included in each unit block 31, 32, and 33 may be different. In this case, the discrete semiconductor devices included in one unit block may not be driven simultaneously, and the level of the gate signals VG provided to the gate electrodes of each semiconductor device included in one unit block may be different each other.

The electric power semiconductor system according to one or more embodiments may include amplification circuits AMP respectively connected to the gate electrode of each high electron mobility transistor H1 to H4. Each of the amplification circuits AMP may provide a gate signal VG to a gate electrode of the high electron mobility transistors H1 to H4 closest to itself, based on the output control signal OCS. According to one or more embodiments, for each gate electrode of the high electron mobility transistors H1 to H4 positioned at different positions in one unit block, the gate signals VG having the substantially same level may be provided at the same point, and thus, the reliability of the switching operation performed by one unit block can be improved.

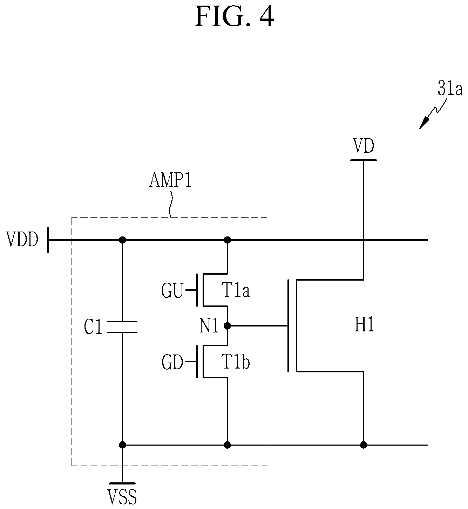

FIG. 4 is a circuit diagram illustrating operation of an amplification circuit according to one or more embodiments. Specifically, FIG. 4 is an enlarged view of the first switching circuit 31a of FIG. 3.

Referring to FIG. 4, the first switching circuit 31a may include the first high electron mobility transistor H1 and the (first) amplification circuitAMP1 connected thereto.

The amplification circuit AMP may include a first transistor T1a, a second transistor T1b coupled in series with the first transistor T1a, and a first capacitor C1 coupled in parallel with the first transistor T1a and the second transistor T1b. Referring to FIG. 4, a drain of the first transistor T1a and a first electrode of the first capacitor C1 may be connected to the first power voltage VDD. A source of the second transistor T1b and a second electrode of the first capacitor C1 may be connected to the second power voltage VSS. A source of the first transistor T1a, a drain of the second transistor T1b, and a gate of the first high electron mobility transistor H1 may be connected to the output node N1. In one or more embodiments, the first transistor T1a and the second transistor T1b may be NMOS transistors. However, not limited thereto, in another embodiment, at least one of the first transistor T1a and the second transistor T1b may be a PMOS transistor.

Hereinafter, referring to FIG. 3 and FIG. 4 together, detailed operation of the amplification circuit AMP during the turn-on and turn-off operation of the high electron mobility transistor H1 will be described.

In the turn-on operation of the first high electron mobility transistor H1, a pull-up signal GU of the first level may be applied to the gate electrode of the first transistor T1a. The first level is a voltage that turns on the first transistor T1a, and, in one or more embodiments, the voltage difference between the first level of the pull-up signal GU and the output node N1 may have a level higher than the threshold voltage of the first transistor T1a. In turn-on operation of the first high electron mobility transistor H1, a pull-down signal GD of a second level may be applied to the gate electrode of the second transistor T1b. The second level may be a voltage that turns off the second transistor T1b. As the first transistor T1a is turned on and the second transistor T1b is turned off, the first power voltage VDD may be applied to the gate electrode of the first high electron mobility transistor H1. As the first power voltage VDD higher than the threshold voltage of the first high electron mobility transistor H1 is applied to the gate electrode of the first high electron mobility transistor H1, the first high electron mobility transistor H1 may be turned on.

In turn-off operation of the first high electron mobility transistor H1, a pull-down signal GD of a first level may be applied to the gate of the second transistor T1b. The first level is a voltage signal that turns on the second transistor T1b, and in one or more embodiments, the voltage difference between the first level of the pull-down signal GD and the second power voltage VSS may have a level higher than the threshold voltage of the second transistor T1b. In the turn-off operation of the first high electron mobility transistor H1, a pull-up signal GU of a second level may be applied to the gate of the first transistor T1a. The second level is a voltage that turns off the first transistor T1a. As the first transistor T1a turns off and the second transistor T1b turns on, the charges charged to the gate of the first high electron mobility transistor H1 may be discharge to outside through the second power supply voltage VSS, and the first high electron mobility transistor H1 may be turned off.

The first capacitor C1 may be a decoupling capacitor. For example, in the turn-on operation of the first high electron mobility transistor H1, the voltage of the gate electrode of the first high electron mobility transistor H1 may rapidly drop to the same level as the second power supply voltage VSS. At this time, due to the first capacitor C1, the voltage of the drain of the first transistor T1a is not affected by the voltage of the gate electrode of the first high electron mobility transistor H1 to be maintained at the same level as the first power voltage VDD.

In FIG. 4, only the first switching circuit 31a is shown, but the detailed configuration and operation of the other switching circuits 31b to 31d included in the first unit block 31(see Fig. 3) may be the same as the detailed configuration and operation of the first switching circuit 31a. In other words, the second switching circuit 31b, third switching circuit 31c, and fourth switching circuit 31d may respectively include components corresponding to first capacitor C1, first transistor T1a, and second transistor T1b included in the first switching circuit 31a.

In the turn-on operation of the high electron mobility transistors H1 to H4 included in the first unit block 31, the voltage stored in the capacitor (e.g., first capacitor C1 in Fig. 4) included in each of the switching circuits 31a to 31d may be provided as a drain voltage of an upper transistor (e.g., first transistor T1a in Fig. 4). In this case, a uniform voltage (e.g., a voltage corresponding to the voltage difference between the first power voltage VDD and the second power voltage VSS) may be provided as a drain voltage of the upper transistor of each switching circuit 31a to 31d regardless of positions of the high electron mobility transistor H1 to H4 in the unit block 31, and thus, each high electron mobility transistor H1 to H4 may be turned on at the substantially same time.

During turn-off operation of the high electron mobility transistors H1 to H4 included in the first unit block 31, the charges charged to the gate electrode of each high electron mobility transistor H1 to H4 may be discharged to the second power voltage VSS via a lower transistor (e.g., second transistor T1b in Fig. 4) included in each of the switching circuits 31a to 31d. In this case, the time it takes for the charges charged to the gate electrode of each high electron mobility transistor H1 to H4 to be completely discharged may be substantially same, regardless of positions of the high electron mobility transistor H1 to H4 in the unit block 31. Accordingly, each high electron mobility transistor H1 to H4 may be turned off at the substantially same time.

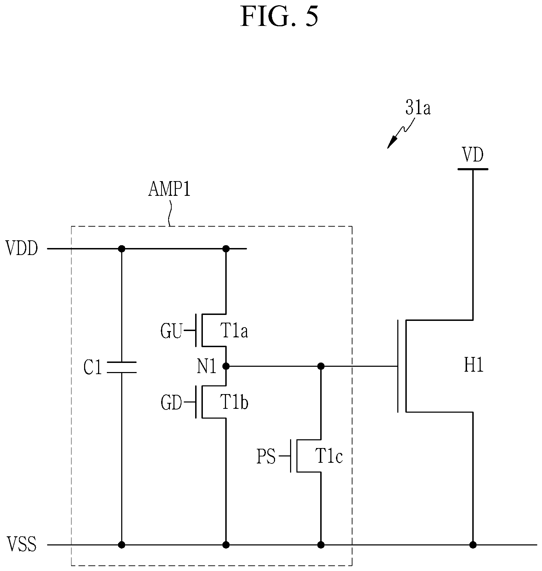

FIG. 5 is a circuit diagram of a switching circuit according to one or more embodiments. Since many parts of the switching circuit shown in FIG. 5 are the same as the switching circuit according to the embodiment described in FIG. 3, hereinafter, the description for those will be omitted, and mainly the differences will be described. The switching circuit according to the embodiment may be slightly different from the previous embodiments in that it includes a third transistor T1c.

Referring to FIG. 5, the first switching circuit 31a may further include a third transistor T1c connected between the gate electrode of the first high electron mobility transistor H1 and the second power voltage VSS. The third transistor T1c may be a transistor for protecting the first high electron mobility transistor H1 when the first high electron mobility transistor H1 is short-circuited.

Specifically, in the turn-on operation of the first high electron mobility transistor H1, a short circuit may occur between the drain and source of the first high electron mobility transistor H1, which causes excessive current to flow between the drain and source. When a short circuit occurs between the drain and source of the first high electron mobility transistor H1, the third transistor T1c may be turned on in response to a protection signal PS received from outside. When the third transistor T1c turns on, the first power voltage VDD voltage may be distributed to both sides of the two transistors T1a and T1b depending on a ratio of the drain-source resistance Rdson of the first transistor T1a and the third transistor T1c. In this case, a lower gate voltage may be applied to the gate of the first high electron mobility transistor H1, compared to the case where the third transistor T1c is not present in the amplification circuit AMP. Accordingly, when a short circuit occurs, the first high electron mobility transistor H1 may be turned off, or the amount of the short circuit current flowing between the drain electrode and the source electrode of the first high electron mobility transistor H1 may be reduced.

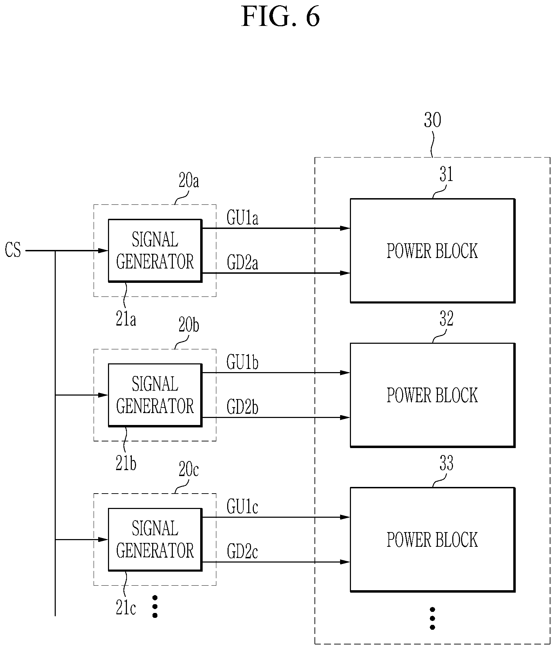

FIG. 6 is a block diagram of an electric power semiconductor system according to one or more embodiments.

Since many parts of the electric power semiconductor system shown in FIG. 6 are the same as the switching circuit electric power semiconductor system according to the embodiment described above, hereinafter, the description for those will be omitted, and mainly the differences will be described. The electric power semiconductor system according to the embodiment may be slightly different from the previous embodiments in that it includes a plurality of gate drivers 20a, 20b, and 20c corresponding to each unit block 31, 32, 33.

Referring to FIG. 6, the electric power semiconductor system according to the embodiment may include a plurality of unit blocks 31, 32, and 33 and a plurality of gate drivers 20a, 20b, and 20c respectively corresponding to one of the plurality of unit blocks 31, 32, and 33. The first gate driver 20a, second gate driver 20b, and third gate driver 20c may include a first signal generator 21a, a second signal generator 21b, and a third signal generator 21c, respectively. Each unit block 31, 32, and 33 included in the semiconductor device 30 may be driven by the pull-up signal GU or pull-down signal GD provided from the corresponding signal generator 21a, 21b, and 21c, respectively. According to the embodiment, the plurality of unit blocks 31, 32, and 33 included in the semiconductor device 30 may be independently driven by corresponding gate drivers 20a, 20b, and 20c.

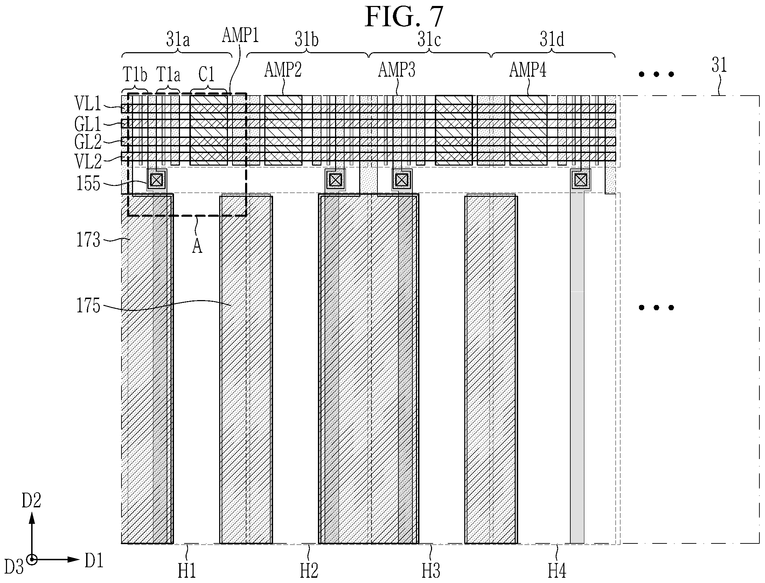

FIG. 7 is a top plan view showing a semiconductor device according to one or more embodiments. Specifically, FIG. 7 illustrates a plan view of the first unit block 31 among the plurality of unit blocks included in the semiconductor device 30 shown in FIG. 3.

In one or more embodiments, the first unit block 31 may include a plurality of switching circuits 31a to 31d. The plurality of switching circuits 31a to 31d included in the first unit block 31 may be positioned on a single substrate. The switching circuits 31a to 31d may be arranged in the first direction D1. In the embodiment, switching circuits 31a to 31d may adjoin each other in the first direction D1. Each of the switching circuits 31a to 31d may have a shape mutually symmetrical to another switching circuit 31a to 31d with respect to an interface with the another switching circuit 31a to 31d adjoined in the first direction D1. For example, referring to FIG. 7, the first switching circuit 31a and the second switching circuit 31b may have shapes symmetrical to each other with respect to an interface that the two switching circuits 31a and 31b are in contact with. The second switching circuit 31b and the third switching circuit 31c may have shapes symmetrical to each other with respect to an interface to which the two switching circuits 31b and 31c are in contact with. The third switching circuit 31c and the fourth switching circuit 31d may have shapes symmetrical to each other with respect to an interface to which the two switching circuits 31c and 31d are in contact with.

The plurality of switching circuits 31a to 31d may include a high electron mobility transistor H1 to H4 and an amplification circuit AMP1 to AMP4, respectively. In each switching circuit 31a to 31d, high electron mobility transistors H1 to H4 and amplification circuits AMP1 to AMP4 may be arranged spaced apart in a second direction D2.

The high electron mobility transistors H1 to H4 included in the switching circuits 31a to 31d may be arranged along the first direction D1. The high electron mobility transistors H1 to H4 may include source electrode 173 and drain electrode 175, respectively. When the high electron mobility transistors H1 to H4 are arranged along the first direction D1, the source electrode 173 and drain electrode 175 included in each of the high electron mobility transistors H1 to H4 may be alternately arranged along the first direction D1 changing the order each other. In other words, in the semiconductor device according to the embodiment, source electrodes 173 and drain electrodes 175 included in high electron mobility transistors H1 to H4 may be arranged along the first direction D1 in an order of 'source electrode-drain electrode/drain electrode-source electrode/source electrode/drain electrode/... `. For example, referring to FIG. 7, the high electron mobility transistors H1to H4 may be arranged sequentially along the first direction D1, in an order of first, second, third and fourth high electron mobility transistors H1, H2, H3, H4. For example, the source electrodes 173 and drain electrodes 175 included in the high electron mobility transistors H1 to H4 are may be sequentially arranged in an order of the source electrode 173 and the drain electrode 175 of the first high electron mobility transistor H1, the drain electrode 175 and the source electrode 173 of the second high electron mobility transistor H2, the source electrode 173 and the drain electrode 175 of the third high electron mobility transistor H3, and the drain electrode 175 and the source electrode 173 of the fourth high electron mobility transistor H4, along the first direction D1.

The source electrode 173 of each of the high electron mobility transistors H1 to H4 may mutually adjoin the source electrode 173 of other high electron mobility transistors H1 to H4 positioned at a side, along the first direction D1. In one or more embodiments, the two source electrodes 173 adjoining each other along the first direction D1 may be formed integrally (i.e. integrated). Accordingly, an interface between the two source electrodes 173 adjoining each other along the first direction D1 may not be recognized. In other words, an interface between the adjoining source electrodes 173 may not be present. Other similarly described unrecognized interfaces may similarly not be present. Referring to FIG. 7, the source electrodes 173 of the first and second high electron mobility transistors H1, and H2 may be formed integrally, and the interface between the source electrodes 173 of the first and second high electron mobility transistors H1 and H2 may not be recognized. The source electrodes 173 of the third and fourth high electron mobility transistors H3, and H4 may be formed integrally, and the interface between the source electrodes 173 of the third and fourth high electron mobility transistors H3 and H4 may not be recognized.

The drain electrode 175 of each of the high electron mobility transistors H1 to H4 may mutually adjoin a drain electrode 175 of the other high electron mobility transistors H1 to H4 positioned at a side, along the first direction. In one or more embodiments, the two drain electrodes 175 adjoining each other along the first direction D1 may be formed integrally. Accordingly, the interface between the two drain electrodes 175 adjoining each other along the first direction D1 may not be recognized. Referring to FIG. 7, the drain electrodes 175 of the second and third high electron mobility transistors H2 and H3 may be formed integrally, and the interface between the drain electrodes 175 of the second and third high electron mobility transistors H2 and H3 may not be recognized.

The amplifying circuits AMP1 to AMP4 included in the switching circuits 31a to 31d may be arranged in the first direction D1. Each of the amplification circuits AMP1 to AMP4 may include a second transistor T1b, a first transistor T1a and a capacitor C1 arranged along the first direction. When the amplification circuits AMP1 to AMP4 are arranged along the first direction D1, the second transistor T1b and capacitor C1 included in each of the amplification circuits AMP1 to AMP4 may be alternately arranged along the first direction D1 changing the order each other. However, even in this case, the position of the first transistor T1a in each amplification circuit AMP1 to AMP4 may not change. In the first amplification circuit AMP1, it can be arranged sequentially in the order of the second transistor T1b, the first transistor T1a, and the capacitor C1, in the second amplification circuit AMP2 in the order of the capacitor C1, the first transistor T1a, and the second transistor T1b, in the third amplification circuit AMP3 in the order of the second transistor T1b, the first transistor T1a, and the capacitor C1, and in the fourth amplification circuit AMP4 in the order of the capacitor C1, the first transistor T1a, and the second transistor T1b along the first direction D1.

Each amplification circuit AMP1 to AMP4 may include a second source electrode 373 positioned at a side. The second source electrode 373 of each of the amplification circuits AMP1 to AMP4 may mutually adjoin the second source electrode 373 of the other amplification circuits AMP1 to AMP4 positioned at a side, along the first direction D1. In one or more embodiments, the two second source electrodes 373 adjoining each other along the first direction D1 may be formed integrally. Accordingly, a boundary between the two second source electrodes 373 adjoining each other along the first direction D1 may not be recognized. Referring to FIG. 7, the second source electrodes 373 of the second and third amplification circuits AMP2, and AMP3 may be formed integrally. An interface between the second source electrodes 373 of the second and third amplification circuits AMP2, and AMP3 may not be recognized.

Each amplification circuit AMP1 to AMP4 may include a conductive pattern 459 positioned at the other side. The conductive pattern 459 of each of the amplifying circuits AMP1 to AMP4 may mutually adjoin a conductive pattern 459 of the other amplifying circuits AMP1 to AMP4 positioned at a side, along the first direction D1. In one or more embodiments, the two conductive patterns 459 adjoining each other along the first direction D1 may be formed integrally. Accordingly, a boundary between two conductive patterns 459 adjoining each other along the first direction D1 may not be recognized. Referring to FIG. 7, the conductive patterns 459 of the first and second amplification circuits AMP1 and AMP2 may be formed integrally. An interface between the conduction patterns 459 of the first and second amplification circuits AMP1 and AMP2 may not be recognized. Referring to FIG. 7, the conductive patterns 459 of the third and fourth amplification circuits AMP3 and AMP4 may be formed integrally. The interface between the conduction patterns 459 of the third and fourth amplification circuits AMP3, and AMP4 may not be recognized.

The first to fourth high electron mobility transistors H1 to H4 may be coupled in parallel with each other. That is, the source electrodes of each of the first to fourth high electron mobility transistors H1 to H4 may be electrically connected to each other, and the drain electrodes may be electrically connected to each other.

In one or more embodiments, the source electrode of each of the high electron mobility transistors H1 to H4 may adjoin a source electrode of one of two high electron mobility transistors positioned (i.e. disposed) at both sides of itself. Referring to FIG. 7, source electrode 173 of the second high electron mobility transistor H2 and source electrode 173 of the third high electron mobility transistor H3 may adjoin each other in the first direction D1. The source electrodes 173 of the second and third high electron mobility transistors H2 and H3, the source electrode 173 of the first high electron mobility transistor H1, and the source electrode 173 of the fourth high electron mobility transistor H4 may be connected to each other through a separate bus line positioned outside the first unit block 31.

In the embodiment, the drain electrode of each of the high electron mobility transistors H1 to H4 may adjoin the drain electrode of one of two high electron mobility transistors positioned at both sides of itself. Referring to FIG. 7, the drain electrode 175 of the first high electron mobility transistor H1 and the drain electrode 175 of the second high electron mobility transistor H2 may adjoin each other in the first direction D1. The drain electrode 175 of the third high electron mobility transistor H3 and the drain electrode 175 of the fourth high electron mobility transistor H4 may adjoin each other in the first direction D1. The drain electrodes 175 of the second and third high electron mobility transistors H2 and H3, the drain electrode 175 of the first high electron mobility transistor H1, and the drain electrode 175 of the fourth high electron mobility transistor H4 may be connected to each other through a separate bus line positioned outside the first unit block 31.

In FIG. 7, a power lines VL1 and VL2 and signal lines GL1 and GL2 may be positioned on the amplification circuits AMP1 to AMP4. That is, power lines VL1, VL2 and signal lines GL1, GL2 may be positioned apart from the amplification circuits AMP1 to AMP4 in a third direction D3. Third direction D3 may be a direction perpendicular to first direction D1 and second direction D2. The power lines VL1 and VL2 and signal lines GL1 and GL2 may be extended in the first direction D1.

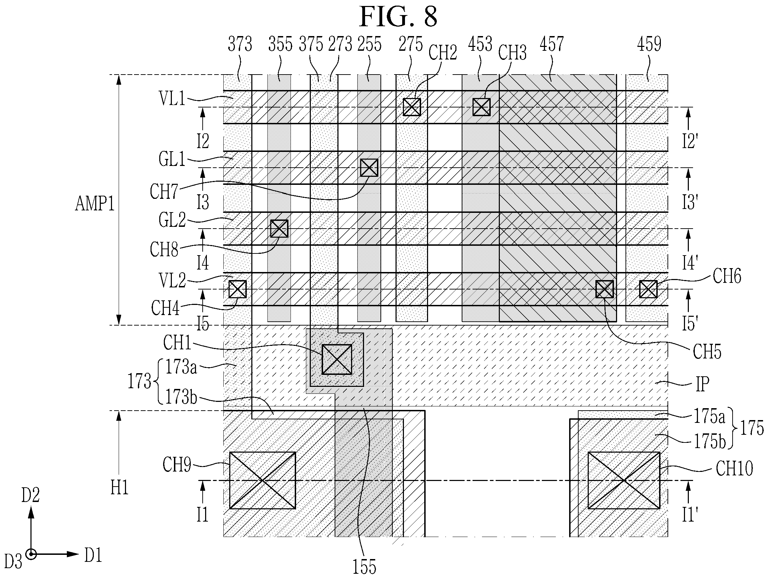

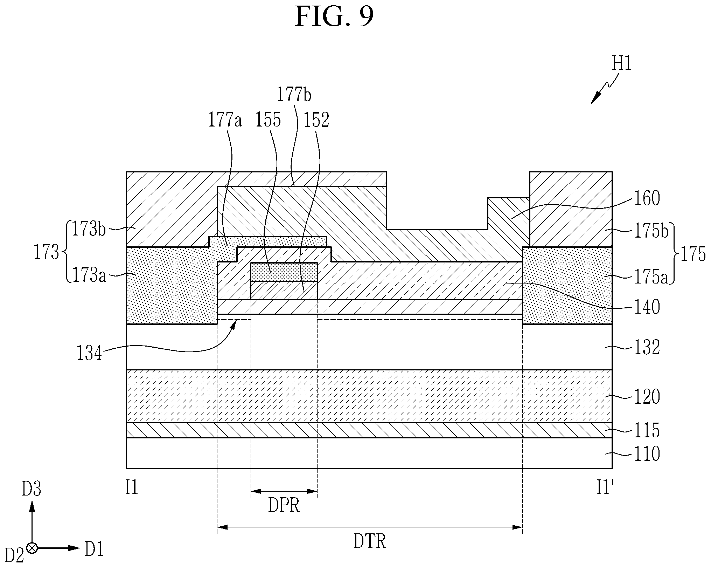

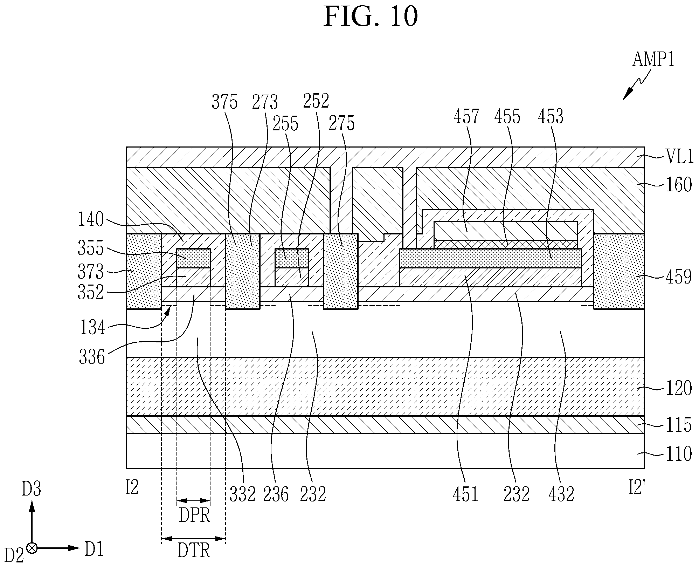

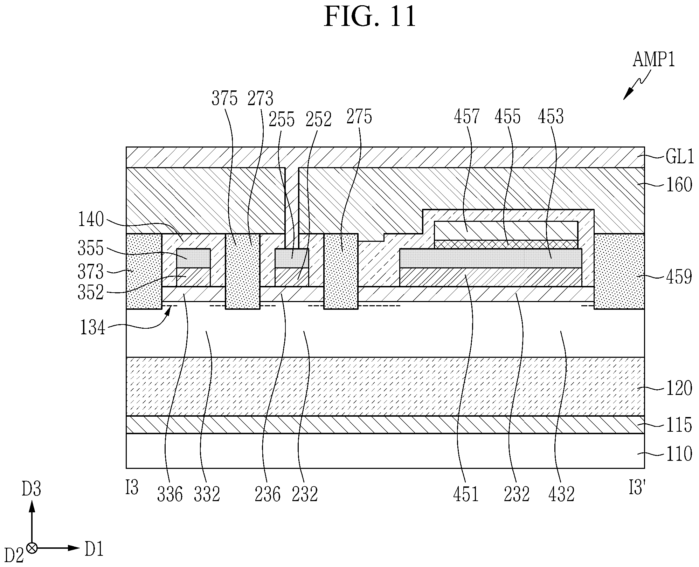

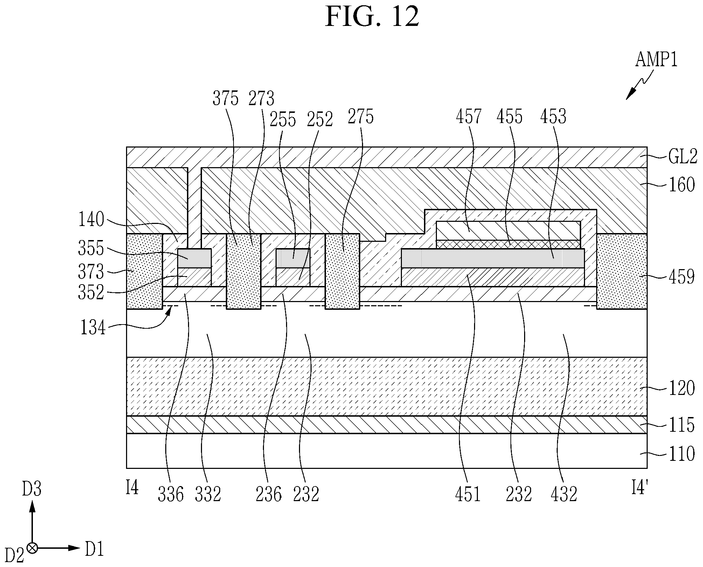

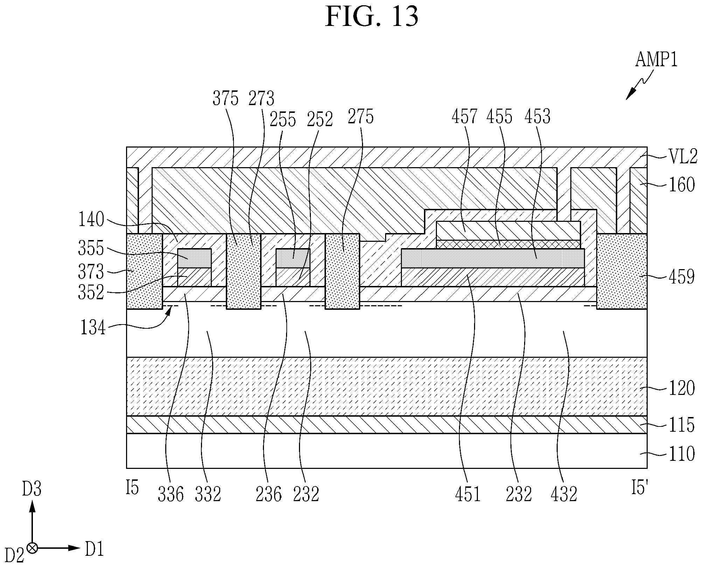

FIG. 8 to FIG. 13 are drawings illustrating the configuration of a semiconductor device according to one or more embodiments. Specifically, FIG. 8 is an enlarged view of a region A of FIG. 7. 8 is FIG., FIG. 9 is a cross-sectional view along the line I1-I1' in FIG. 8, FIG. 10 is a cross-sectional view along the I2-I2' line in FIG. 8, FIG. 11 is a cross-sectional view along the I3-I3' line in FIG. 8, FIG. 12 is a cross-sectional view along the I42-I4' line in FIG. 8, and FIG. 13 is a cross-sectional view along the I5-I5' line in FIG. 8.

First, referring to FIG. 8 and FIG. 9, the specific configurations of the first high electron mobility transistor H1 according to one or more embodiments will be described. FIG. 8 and FIG. 9 illustrate the first high electron mobility transistor H1, but the detailed configurations of the second to fourth high electron mobility transistors (H2-H4) may be substantially same as the first high electron mobility transistor H1. The first high electron mobility transistor H1 according to the embodiment may include a channel layer 132, a barrier layer 136 on the channel layer 132, a gate electrode 155 on the barrier layer 136, a source electrode 173 and a drain electrode 175 at both sides of the gate electrode 155.

The channel layer 132 is a layer forming a channel between the source electrode 173 and the drain electrode 175, and a two-dimensional electron gas 134 may be positioned inside the channel layer 132. Two-dimensional electron gas 134 is a charge transport model used in solid physic and refers to a group of electrons capable of freely moving in a 2-dimension space (e.g., x-y plane) but tightly bound in the two-dimensional space not to move in another dimension (e.g., z-direction). In other words, two-dimensional electron gas 134 may exist in a form as a two-dimensional paper in a 3-dimensional space. This two-dimensional electron gas 134 mainly appears in a semiconductor heterojunction structure and may be generated at an interface between the channel layer 132 and the barrier layer 136 in a first high electron mobility transistor H1 according to one or more embodiments. For example, two-dimensional electron gas 134 may be generated, in the channel layer 132, at a portion closest to the barrier layer 136.

The channel layer 132 may include one or more materials selected from nitrides containing at least one of Group III-V materials, for example, Al, Ga, In, and B. The channel layer 132 may be made of a single layer or multiple layers. The channel layer 132 may be AlₓIn_{y}Ga_{1-x-y}N (0≤x≤1, 0≤y≤1, x+y≤1). For example, the channel layer 132 may include at least one of AlN, GaN, InN, InGaN, AlGaN, AlInN, and AlInGaN. The channel layer 132 may be an impurity doped layer or an impurity undoped layer. The thickness of the channel layer 132 may be approximately several hundred nm or less.

The channel layer 132 may be positioned on the substrate 110, and a seed layer 115, a buffer layer 120, and the like may be positioned between the substrate 110 and the channel layer 132. The substrate 110, the seed layer 115, and the buffer layer 120 are layers necessary to form the channel layer 132 and may be omitted in some cases. For example, when a substrate made of GaN is used as the channel layer 132, at least one of the substrate 110, the seed layer 115, and the buffer layer 120 may be omitted. Considering that the price of a substrate made of GaN is relatively high, a channel layer 132 containing GaN may be grown using a substrate 110 made of Si. In this case, since the lattice structure of Si and the lattice structure of GaN are different, it may not be easy to grow the channel layer 132 directly on the substrate 110. Accordingly, after growing the seed layer 115 and buffer layer 120 on the substrate 110 first, the channel layer 132 may be grown on the buffer layer 120. Also, at least one of the substrate 110, the seed layer 115, and the buffer layer 120 may be used in manufacturing process then to be removed from a final structure of the first high electron mobility transistor H1.

The substrate 110 may include semiconductor material. For example, the substrate 110 may include sapphire, Si, SiC, AlN, GaN, or a combination thereof. The substrate 110 may be a SOI (Silicon on Insulator) substrate. However, the material of substrate 110 is not limited to those, and any generally-used substrate may be used. In some cases, substrate 110 may include an insulating material. For example, after forming several layers including the channel layer 132 on a semiconductor substrate, the semiconductor substrate may be removed and replaced with an insulating substrate.

The seed layer 115 may be positioned on the substrate 110. The seed layer 115 may be positioned directly on the substrate 110. However, not limited thereto, other layers may be further positioned between the substrate 110 and the seed layer 115. The seed layer 115 is a layer serving as a seed for growing the buffer layer 120, and may be made of a crystal lattice structure that becomes the seed of the buffer layer 120. For example, seed layer 115 may contain AlN, but is not limited thereto.

The buffer layer 120 may be positioned on the seed layer 115. The buffer layer 120 may be positioned directly on the seed layer 115. However, not limited thereto, and other layers may be positioned between the seed layer 115 and the buffer layer 120. The buffer layer 120 may be positioned between the seed layer 115 and the channel layer 132. The buffer layer 120 may include one or more materials selected from nitrides containing at least one of Group III-V materials, for example, Al, Ga, In, and B. The buffer layer 120 may be AlₓIn_{y}Ga_{1-x-y}N (0≤x≤1, 0≤y≤1, x+y≤1). For example, the buffer layer 120 may include at least one of AlN, GaN, InN, InGaN, AlGaN, AlInN, and AlInGaN. The buffer layer 120 may be made of a single layer or multiple layers. For example, the buffer layer 120 may include a superlattice layer and a high-resistance layer.

The superlattice layer may be a layer for alleviating the difference in lattice constant and thermal expansion coefficient between the substrate 110 and the channel layer 132, alleviating the tensile stress and compressive stress generated between the substrate 110 and the channel layer 132 due to the difference. The high-resistance layer is a layer for preventing the first high electron mobility transistor H1 according to one or more embodiments from being deteriorated by preventing leakage current from flowing through the channel layer 132. For those purpose, the high-resistance layer may be made of a material with low conductivity so that the substrate 110 and the channel layer 132 are electrically insulated.

The barrier layer 136 may be positioned on the channel layer 132. The barrier layer 136 can be positioned directly on the channel layer 132. However, not limited thereto, and other layers may be positioned between the channel layer 132 and the barrier layer 136. The region of the channel layer 132 overlapping the barrier layer 136 in the third direction D3 may be a drift region DTR. The drift region DTR may be positioned between source electrode 173 and drain electrode 175. When a voltage difference occurs between the source electrode 173 and the drain electrode 175, carriers may move in the drift region DTR. Depending on whether a voltage is applied to the gate electrode 155 and the magnitude of the voltage applied to the gate electrode 155, the first high electron mobility transistor H1 according to one or more embodiments may be turned on/off. When a voltage higher than the threshold voltage is applied to the gate electrode 155 and the first high electron mobility transistor H1 is turned on, a channel may be created in the depletion region DPR. Accordingly, the carriers can move in the drift region DTR. If a voltage lower than the threshold voltage is applied to the gate electrode 155 or no voltage is applied, the channel path may be cut off in the depletion region DPR and carrier movement may not occur.

The barrier layer 136 may include one or more materials selected from nitrides containing one of Group III-V materials, for example, Al, Ga, In, and B. The barrier layer 136 may be AlₓIn_{y}Ga_{1-x-y}N (0≤x≤1, 0≤y≤1, x+y≤1). The barrier layer 136 may include at least one of GaN, InN, AlGaN, AlInN, InGaN, AlN, AlInGaN, etc. The energy band gap of the barrier layer 136 may be adjusted by the composition ratio of Al or In. The barrier layer 136 may be doped with a predetermined impurity. At this time, the impurity doped in the barrier layer 136 may be a P-type dopant capable of providing holes. For example, the impurity doped in the barrier layer 136 may be magnesium (Mg). By increasing or decreasing the impurity doping concentration of the barrier layer 136, the threshold voltage, on-resistance, and the like of the first high electron mobility transistor H1 according to one or more embodiments may be adjusted.

The barrier layer 136 may include a semiconductor material having characteristics different from those of the channel layer 132. The barrier layer 136 may be different from the channel layer 132 in at least one of polarization characteristic, energy band gap, and lattice constant. For example, the barrier layer 136 may include a material having an energy band gap different from the channel layer 132. At this time, the barrier layer 136 may have a higher energy band gap than the channel layer 132, and a higher electrical polarization rate than the channel layer 132. By such barrier layer 136, two-dimensional electron gas 134 may be induced in the channel layer 132 having a relatively low electrical polarization rate. In this regard, the barrier layer 136 may be called a channel supply layer or a two-dimensional electron gas supply layer. The two-dimensional electron gas 134 may be formed in a portion of the channel layer 132, which is positioned below an interface between the channel layer 132 and the barrier layer 136. Two-dimensional electron gas 134 may have very high electron mobility.

The gate electrode 155 may be positioned on barrier layer 136. The gate electrode 155 may overlap some regions of barrier layer 136 in the third direction D3. The gate electrode 155 may overlap a part of the drift region DTR of the channel layer 132 in the third direction D3. The gate electrode 155 may be positioned between source electrode 173 and drain electrode 175. The gate electrode 155 may be spaced apart from source electrode 173 and drain electrode 175. The gate electrode 155 may be extended along the second direction D2 on a plane. In other words, the gate electrode 155 may have a shape of a bar extending along the second direction D2 on a plane.

The gate electrode 155 may contain conductive material. For example, the gate electrode 155 may include metal, metal alloy, conductive metal nitride, metal silicide, doped semiconductor material, conductive metal oxide, or conductive metal nitride oxide. For example, the gate electrode 155 may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride. (TiAlN), tantalum aluminum nitride(TaAlN), tungsten nitride(WN), ruthenium(Ru), titanium aluminum(TiAl), titanium aluminum carbonitride(TiAIC-N), titanium aluminum carbide(TiAlC), titanium carbide(TiC), tantalum carbonitride(TaCN), tungsten(W), aluminum(Al), copper(Cu), cobalt(Co), titanium(Ti), tantalum(Ta), nickel(Ni), platinum(Pt), nickel platinum(Ni) -Pt), niobium(Nb), niobium nitride(NbN), niobium carbide(NbC), molybdenum(Mo), molybdenum nitride(MoN), molybdenum carbide(MoC), tungsten carbide(WC), rhodium(Rh), palladium It may include (Pd), iridium (Ir), osmium (Os), silver (Ag), gold (Au), zinc (Zn), vanadium (V), or combinations thereof, but not limited thereto. The gate electrode 155 may be made of a single layer or multiple layers.

The first high electron mobility transistor H1 according to the embodiment may further include a gate semiconductor layer 152 positioned between the barrier layer 136 and the gate electrode 155. That is, the gate semiconductor layer 152 may be positioned on the barrier layer 136, and the gate electrode 155 may be positioned on the gate semiconductor layer 152. The gate electrode 155 may be in Schottky contact with the gate semiconductor layer 152. However, not limited thereto, in some cases, the gate electrode 155 may be in ohmic contact with the gate semiconductor layer 152. The gate semiconductor layer 152 may overlap the gate electrode 155 in the third direction D3. At this time, the gate semiconductor layer 152 may completely overlap the gate electrode 155 in a third direction D3. The third direction D3 is a direction vertical to the first direction D1 and the second direction D2, and may be vertical to a top surface of the channel layer 132 or barrier layer 136. The top surface of the gate semiconductor layer 152 may be entirely covered by the gate electrode 155. That is, the gate semiconductor layer 152 may have the substantially same planar shape as the gate electrode 155.

The gate semiconductor layer 152 may be positioned between the source electrode 173 and the drain electrode 175. The gate semiconductor layer 152 may be spaced apart from the source electrode 173 and the drain electrode 175. The gate semiconductor layer 152 may be positioned closer to the source electrode 173 than to the drain electrode 175. That is, a separation distance between the gate semiconductor layer 152 and the source electrode 173 may be smaller than a separation distance between the gate semiconductor layer 152 and the drain electrode 175.

The gate semiconductor layer 152 may include one or more materials selected from nitrides containing at least one of Group III-V materials, for example, Al, Ga, In, and B. The gate semiconductor layer 152 may be AlₓIn_{y}Ga_{1-x-y}N (0≤x≤1, 0≤y≤1, x+y≤1). For example, the gate semiconductor layer 152 may include at least one of AlN, GaN, InN, InGaN, AlGaN, AlInN, and AlInGaN. The gate semiconductor layer 152 may include a material having an energy band gap different from the barrier layer 136. For example, the gate semiconductor layer 152 may include GaN, and the barrier layer 136 may include AlGaN. The gate semiconductor layer 152 may be doped with a predetermined impurity. At this time, the impurity doped in the gate semiconductor layer 152 may be a P-type dopant capable of providing holes. For example, gate semiconductor layer 152 may include GaN doped with P-type impurity. That is, the gate semiconductor layer 152 may be made of a p-GaN layer. However, not limited thereto, the gate semiconductor layer 152 may be a p-AlGaN layer. The impurity doped in the gate semiconductor layer 152 may be magnesium (Mg). The gate semiconductor layer 152 may be made of a single layer or multiple layers.

A depletion region DPR may be formed in the channel layer 132 by the gate semiconductor layer 152. The depletion region DPR may be positioned in the drift region DTR and have a width narrower than the drift region DTR. As the gate semiconductor layer 152 having an energy band gap different from that of the barrier layer 136 is positioned on the barrier layer 136, the level of the energy band of a portion of the barrier layer 136 overlapping the gate semiconductor layer 152 may increase. Accordingly, a depletion region DPR may be formed in a region of the channel layer 132 overlapping the gate semiconductor layer 152. The depletion region DPR is a region in which two-dimensional electron gas 134 is not formed, or a region which has an electron concentration lower than the remaining regions, among a channel path of the channel layer 132. In other words, the depletion region DPR may refers to a region where the flow of two-dimensional electron gas 134 is cut off in the drift region DTR. As a depletion region DPR is generated, currents do not flow between the source electrode 173 and the drain electrode 175, and the channel path may be cut off. Accordingly, the first high electron mobility transistor H1 according to one or more embodiments may have a normally off characteristic.

That is, the first high electron mobility transistor H1 according to one or more embodiments may be a normally off first high electron mobility transistor (HEMT) H1. As shown in FIG. 1, in a normal state where no voltage is applied to the gate electrode 155, a depletion region DPR exists, and the first high electron mobility transistor H1 according to one or more embodiments may be in an off state. When a voltage higher than a threshold voltage is applied to the gate electrode 155, the depletion region DPR disappears, and the two-dimensional electron gas 134 is not cut off in the drift region DTR and may be connected. In other words, the two-dimensional electron gas 134 may be formed in the entire channel path between the source electrode 173 and the drain electrode 175, and the first high electron mobility transistor H1 according to one or more embodiments may become in on-state. In summary, the first high electron mobility transistor H1 according to one or more embodiments may include semiconductor layers having different electrical polarization characteristics, and a semiconductor layer having a relatively large polarization may induce two-dimensional electron gas 134 to another hetero-junction semiconductor layer thereto. Such two-dimensional electron gas 134 may be used as a channel between the source electrode 173 and the drain electrode 175, and connection or disconnection of the flow of such two-dimensional electron gas 134 may be controlled by a bias voltage applied to the gate electrode 155. In the gate-off state, the flow of the two-dimensional electron gas 134 is cut off, so current may not flow between the source electrode 173 and the drain electrode 175. In the gate-on state, since the flow of two-dimensional electron gas 134 continues current may flow between the source electrode 173 and the drain electrode 175.

In the above, a case where the first high electron mobility transistor H1 according to one or more embodiments is a normally off high electron mobility transistor has been described, but the embodiments are not limited thereto. For example, the first high electron mobility transistor H1 according to one or more embodiments may be a normally on high electron mobility transistor. In a normally on high electron mobility transistor, the gate semiconductor layer 152 may be omitted, and thus the gate electrode 155 may be positioned directly on the barrier layer 136. That is, the gate electrode 155 may contact the barrier layer 136. In this structure, when no voltage is applied to the gate electrode 155, the two-dimensional electron gas 134 may be used as a channel and a current flow may occurs between the source electrode 173 and the drain electrode 175. Also, when a negative voltage is applied to the gate electrode 155, a depletion region DPR where the flow of two-dimensional electron gas 134 is cut off may be generated at a lower portion of the gate electrode 155.

The buffer layer 120, the channel layer 132, the barrier layer 136, and the gate semiconductor layer 152 described above may be sequentially stacked on the substrate 110. In the first high electron mobility transistor H1 according to one or more embodiments, at least one of the buffer layer 120, the channel layer 132, the barrier layer 136, and the gate semiconductor layer 152 may be omitted. These buffer layer 120, channel layer 132, barrier layer 136, and gate semiconductor layer 152 may be made of a semiconductor material with the same basis, and the composition ratios of each layer may be different, considering the role of each layer and the performance desired for the first high electron mobility transistor H1.

The first high electron mobility transistor H1 according to one or more embodiments may further include protective layers 140 and 160 positioned on the barrier layer 136 and the gate electrode 155. The protective layers 140 and 160 may include a first protective layer 140, and a second protective layer 160 positioned on the first protective layer 140. The first protective layer 140 and the second protective layer 160 may cover a top surface of the barrier layer 136 and the gate electrode 155 and cover the side surfaces of the gate electrode 155 and the gate semiconductor layer 152. A bottom surface of the first protective layer 140 may be in contact with the barrier layer 136, the gate electrode 155, and the gate semiconductor layer 152. Atop surface of the first protective layer 140 may be in contact with the second protective layer 160. The second protective layer 160 may be spaced apart from the barrier layer 136, the gate electrode 155, and the gate semiconductor layer 152 by the first protective layer 140. Accordingly, the second protective layer 160 may not contact the barrier layer 136, the gate electrode 155, and the gate semiconductor layer 152.

The barrier layer 136 and gate electrode 155 may be protected by the protective layers 140 and 160 and may be separated from other components. The first protective layer 140 and the second protective layer 160 may include an insulating material. For example, the first protective layer 140 and the second protective layer 160 may include oxide such as SiO₂ or Al₂O₃. As another example, the first protective layer 140 and the second protective layer 160 may include nitride such as SiN or oxide nitride such as SiON. The first protective layer 140 and the second protective layer 160 may include the same material or may be different materials. If the first protective layer 140 and the second protective layer 160 are made of the same material, the boundary between the first protective layer 140 and the second protective layer 160 may not be recognized. The first protective layer 140 and the second protective layer 160 may respectively be made of a single layer or multiple layers.

The source electrode 173 and the drain electrode 175 may be positioned on the channel layer 132. The source electrode 173 and the drain electrode 175 may be spaced apart from each other, and the gate electrode 155 and the gate semiconductor layer 152 may be positioned between the source electrode 173 and the drain electrode 175. The gate electrode 155 and the gate semiconductor layer 152 are spaced apart from source electrode 173 and drain electrode 175. The source electrode 173 may be electrically connected to the channel layer 132 at a side of the gate electrode 155. The drain electrode 175 may be electrically connected to the channel layer 132 at the other side of the gate electrode 155. The source electrode 173 and drain electrode 175 may be positioned outside the drift region DTR of the channel layer 132. The interface between the source electrode 173 and the channel layer 132 may be an edge of the drift region DTR. Likewise, the interface between the drain electrode 175 and the channel layer 132 may be the other edge of the drift region DTR. However, not limited thereto, the source electrode 173 and the drain electrode 175 may not be positioned outside the drift region DTR of the channel layer 132. At this time, the channel layer 132 may not be recessed, and the source electrode 173 and drain electrode 175 may be positioned on the top surface of the channel layer 132. Bottom surfaces of the source electrode 173 and the drain electrode 175 may be in contact with the top surface of the channel layer 132. A portion of the channel layer 132 in contact with the source electrode 173 and the drain electrode 175 may be doped at high concentration. At this time, the carriers that passed through the two-dimensional electron gas 134 may pass through the portion of the channel layer 132 doped at high concentration, i.e., the upper portion of the two-dimensional electron gas 134, and may be transferred to the source electrode 173 and the drain electrode 175. The source electrode 173 and the drain electrode 175 may not directly contact the two-dimensional electron gas 134 in a horizontal direction. The horizontal direction may refer to a direction parallel to the top surface of the channel layer 132 or barrier layer 136.

The source electrode 173 and the drain electrode 175 may extend along the second direction D2 in the plane. That is, the source electrode 173 and drain electrode 175 may have a shape of a bar extending along the second direction D2 on the plane. The source electrode 173 and the drain electrode 175 may extend in parallel directions. The source electrode 173 and the drain electrode 175 may extend in a direction parallel to the gate electrode 155.

The source electrode 173 and the drain electrode 175 may include conductive material. For example, the source electrode 173 and the drain electrode 175 may include metal, metal alloy, conductive metal nitride, metal silicide, doped semiconductor material, conductive metal oxide, or conductive metal nitride oxide. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN). , titanium aluminum nitride(TiAlN), tantalum aluminum nitride(TaAlN), tungsten nitride(WN), ruthenium(Ru), titanium aluminum(TiAl), titanium aluminum carbonitride(TiAIC-N), titanium aluminum carbide(TiAlC), titanium carbide (TiC), tantalum carbonitride(TaCN), tungsten(W), aluminum(Al), copper(Cu), cobalt(Co), titanium(Ti), tantalum(Ta), nickel(Ni), platinum(Pt), nickel platinum(Ni-Pt), niobium(Nb), niobium nitride(NbN), niobium carbide(NbC), molybdenum(Mo), molybdenum nitride(MoN), molybdenum carbide(MoC), tungsten carbide(WC), rhodium(Rh), palladium (Pd), iridium (Ir), osmium (Os), silver (Ag), gold (Au), zinc (Zn), vanadium (V), or combinations thereof, but limited thereto. The source electrode 173 and the drain electrode 175 may be made of a single layer or multiple layers. The source electrode 173 and drain electrode 175 may be in ohmic contact with the channel layer 132. A region in contact with the source electrode 173 and drain electrode 175 in the channel layer 132 may be doped at a relatively high concentration compared to other regions.

The source electrode 173 may include a lower source electrode 173a and an upper source electrode 173b. The upper source electrode 173b may be positioned on the lower source electrode 173a. The lower source electrode 173a may be in direct contact with the channel layer 132 and electrically connected to the channel layer 132. The upper source electrode 173b may not be in direct contact with the channel layer 132, and may be electrically connected to the channel layer 132 through the lower source electrode 173a.

The drain electrode 175 may include a lower drain electrode 175a and an upper drain electrode 175b. The upper drain electrode 175b may be positioned above the lower drain electrode 175a. The lower drain electrode 175a may be in direct contact with the channel layer 132 and electrically connected to the channel layer 132. The upper drain electrode 175b may not be in direct contact with the channel layer 132, and may be electrically connected to the channel layer 132 through the lower drain electrode 175a.

The lower source electrode 173a and the lower drain electrode 175a may be positioned on the first protective layer 140. The lower source electrode 173a and the lower drain electrode 175a may be positioned between the first protective layer 140 and the second protective layer 160. Trenches which penetrate the first protective layer 140 and the barrier layer 136 and recess the top surface of the channel layer 132 may be positioned so as to be spaced apart from each other at both sides of the gate electrode 155. The lower source electrode 173a and the lower drain electrode 175a may be positioned in the trenches positioned at both sides (i.e. on opposite sides) of the gate electrode 155, respectively. The lower source electrode 173a and the lower drain electrode 175a may be formed to fill inside the trenches. In the trench, the lower source electrode 173a and the lower drain electrode 175a may be in contact with the channel layer 132 and the barrier layer 136. The channel layer 132 may form the bottom surface and the sidewall of the trench, and the barrier layer 136 may form the sidewall of the trench.

Also, the lower source electrode 173a and the lower drain electrode 175a may contact the side surface of the barrier layer 136. In other words, the lower source electrode 173a and the lower drain electrode 175a may cover the side surfaces of the channel layer 132 and the barrier layer 136. The top surfaces of the lower source electrode 173a and the lower drain electrode 175a may be protruded from the top surface of the first protective layer 140. Additionally, at least one of the lower source electrode 173a and the lower drain electrode 175a may cover at least a part of the top surface of the first protective layer 140. A second protective layer 160 may be positioned on the lower source electrode 173a and the lower drain electrode 175a. At least a part of the lower source electrode 173a and the lower drain electrode 175a may be covered by the second protective layer 160.

The first high electron mobility transistor H1 according to one or more embodiments may further include a first field dispersing layer 177a positioned above the first protective layer 140. The first field dispersing layer 177a may be positioned between the source electrode 173 and the drain electrode 175. The first field dispersing layer 177a may overlap gate electrode 155 and third direction D3. The gate electrode 155 may be covered by first field dispersing layer 177a. The first field dispersing layer 177a may be electrically connected to the source electrode 173. For example, the first field dispersing layer 177a may be connected to the lower source electrode 173a. The first field dispersing layer 177a may include the same material as the lower source electrode 173a and may be positioned at (i.e. disposed in) the same layer as the lower source electrode 173a. The first field dispersing layer 177a may be simultaneously formed with the lower source electrode 173a in the same process. The boundary between the first field dispersing layer 177a and the lower source electrode 173a may not be clear, and the first field dispersing layer 177a may be formed integrally with the lower source electrode 173a. However, not limited thereto, the first field dispersing layer 177a may be a separate component separated from the lower source electrode 173a. Also, the first field dispersing layer 177a may be positioned at a different layer from the lower source electrode 173a and may be formed in a different process. In some cases, the first field dispersing layer 177a may be electrically connected to the gate electrode 155. For example, an opening overlapping the gate electrode 155 may be formed in the first protective layer 140, and the first field dispersing layer 177a may be connected to the gate electrode 155 through the opening. At this time, the first field dispersing layer 177a may not be connected to the source electrode 173.

The first field dispersing layer 177a may serve to disperse an electric field concentrated around the gate electrode 155. In the gate-off state, the two-dimensional electron gas 134 may be positioned at a portion of the channel layer 132 between the gate electrode 155 and the source electrode 173 and at a portion of the channel layer 132 between the gate electrode 155 and the drain electrode 175, with a very high concentration. When the electric field is concentrated on the gate electrode 155 and the gate semiconductor layer 152, leakage current may increase and breakdown voltage may decrease. The first high electron mobility transistor H1 according to one or more embodiments includes the first field dispersing layer 177a, so may disperse the electric field concentrated around the gate electrode 155. Accordingly, leakage current can be reduced, and breakdown voltage can be increased.

The first high electron mobility transistor H1 according to one or more embodiments may further include a second field dispersing layer 177b positioned on the second protective layer 160. The second field dispersing layer 177b may form a field dispersing layer together with the first field dispersing layer 177a. The second field dispersing layer 177b may be positioned between the source electrode 173 and the drain electrode 175. The second field dispersing layer 177b may overlap gate electrode 155 in the third direction D3. The second field dispersing layer 177b may overlap the first field dispersing layer 177a in the third direction D3. The gate electrode 155 and the first field dispersing layer 177a may be covered by the second field dispersing layer 177b. The second field dispersing layer 177b may be wider than the first field dispersing layer 177a. The second field dispersing layer 177b may entirely cover the first field dispersing layer 177a. However, not limited thereto, the widths and positions of the first field dispersing layer 177a and the second field dispersing layer 177b may be changed in various ways. The second field dispersing layer 177b may be electrically connected to the source electrode 173. For example, the second field dispersing layer 177b may be connected to the upper source electrode 173b. The second field dispersing layer 177b may include the same material as the upper source electrode 173b and may be positioned at the same layer as the upper source electrode 173b. The second field dispersing layer 177b may be simultaneously formed with the upper source electrode 173b in the same process. The boundary between the second field dispersing layer 177b and the upper source electrode 173b may not be clear, and the second field dispersing layer 177b may be formed integrally with the upper source electrode 173b. In other words, no boundary may be present between the second field dispersing layer 177b and the upper source electrode 173b. Other unclear boundaries may similarly not be present. However, not limited thereto, the second field dispersing layer 177b may be a separate component separated from the upper source electrode 173b. Also, the second field dispersing layer 177b may be positioned at a layer different from the upper source electrode 173b and may be formed in a different process. In some cases, the second field dispersing layer 177b may be electrically connected to the gate electrode 155. For example, the first field dispersing layer 177a may be connected to the gate electrode 155 through an opening formed in the first protective layer 140, and the second field dispersing layer 177b may be connected to the first field dispersing layer 177a through an opening formed in the second protective layer 160.

In some cases, at least one of the field dispersing layers 177a and 177b may be omitted. For example, the first high electron mobility transistor H1 according to one or more embodiments includes the first field dispersing layer 177a but may not include the second field dispersing layer 177b. Alternatively, the first high electron mobility transistor H1 according to one or more embodiments includes the second field dispersing layer 177b but may not include the first field dispersing layer 177a. Alternatively, the first high electron mobility transistor H1 according to one or more embodiments may not include the first field dispersing layer 177a and the second field dispersing layer 177b.

The first high electron mobility transistor H1 according to one or more embodiments may further include an interlayer insulating layer 180 positioned on the source electrode 173 and the drain electrode 175. The interlayer insulating layer 180 may cover the upper source electrode 173b, the upper drain electrode 175b, and the second protective layer 160. The top surface and at least a portion of side surface of the upper source electrode 173b may be covered by the interlayer insulating layer 180. The top surface and at least a portion of side surface of the upper drain electrode 175b may be covered by the interlayer insulating layer 180. The top surface of the second protective layer 160 may be covered by the interlayer insulating layer 180. The interlayer insulating layer 180 may be in contact with the upper source electrode 173b, the upper drain electrode 175b, and the second protective layer 160. However, not limited thereto, other layers may be positioned between the upper source electrode 173b, the upper drain electrode 175b, the second protective layer 160, and the interlayer insulating layer 180.

The interlayer insulating layer 180 may include an insulating material. For example, the interlayer insulating layer 180 may include an insulating material such as SiO2, Al2O3, SiN, SiON, etc. The interlayer insulating layer 180 may include the same material as the protective layers 140, and 160, or may include a different material. If the interlayer insulating layer 180 is made of the same material as the second protective layer 160, the boundary between the interlayer insulating layer 180 and the second protective layer 160 may not be recognized. The interlayer insulating layer 180 may be made of a single layer or multiple layers.

Hereinafter, referring to FIG. 8, FIG. 10 to FIG. 13, specific configurations of the amplification circuit according to the embodiment will be described. Referring to FIG. 8, FIG. 10 to FIG. 13, the first amplification circuit AMP1 according to the embodiment may include a first transistor T1a, a second transistor T1b positioned at a side of the first transistor T1a, and a capacitor C1 positioned at the other side of the first transistor T1a.

The first transistor T1a may include a first channel layer 232, a first barrier layer 236 positioned on the first channel layer 232, a first gate electrode 255 positioned on the first barrier layer 236, and a first source electrode 273 and a first drain electrode 275 positioned at both sides (i.e. on opposite sides) of the first gate electrode 255.

The first channel layer 232 may be a layer that forms a channel between the first source electrode 273 and the first drain electrode 275. Two-dimensional electron gas 134 may be positioned in the first channel layer 232. Two-dimensional electron gas may be generated at the interface between the first channel layer 232 and the first barrier layer 236. For example, two-dimensional electron gas 134 may be generated, in the first channel layer 232, at a portion closest to the first barrier layer 236.

The first channel layer 232 may be positioned at the same layer as the channel layer 132 (see Fig. 9) of the first high electron mobility transistor H1, i.e., the same position in the third direction D3. The first channel layer 232 may include the same material as the channel layer 132 of the first high electron mobility transistor H1 and may be formed in the same process. The first channel layer 232 may include one or more materials selected from nitrides containing at least one of a group III-V materials, for example, Al, Ga, In, and B. The first channel layer 232 may be made of a single layer or multiple layers. The first channel layer 232 may be AlₓIn_{y}Ga_{1-x-y}N (0≤x≤1, 0≤y≤1, x+y≤1). For example, the first channel layer 232 may include at least one of AlN, GaN, InN, InGaN, AlGaN, AlInN, and AlInGaN. The first channel layer 232 may be an impurity doped layer or an impurity undoped layer. The thickness of the first channel layer 232 may be approximately several hundred nm or less.

The first channel layer 232 may be positioned on the substrate 110, and a seed layer 115, a buffer layer 120, and the like may be positioned between the substrate 110 and the first channel layer 232. That is, the first channel layer 232 may be simultaneously formed with the channel layer 132 of the first high electron mobility transistor H1 on the same substrate 110, using the same process. In other words, after forming the seed layer 115 and the buffer layer 120 on the substrate 110, the channel layer 132 and the first channel layer 232 may be simultaneously formed on the buffer layer 120. The channel layer 132 and the first channel layer 232 may be positioned apart from each other in the second direction D2. The channel layer 132 and first channel layer 232 may be separated from each other by a separation pattern IP shown in FIG. 8. The positions of the channel layer 132 and the first channel layer 232 on the substrate 110 may be defined by the separation pattern IP. The separation pattern IP may be positioned between the channel layer 132 and the first channel layer 232. In a state that the channel material layer has formed on the buffer layer, the separation pattern IP may be formed by injection a material such as Ar using the ion implant method. The channel layer 132 and the first channel layer 232 spaced apart from each other may be formed by such separation pattern IP.

The first barrier layer 236 may be positioned on the first channel layer 232. The first barrier layer 236 may be positioned directly on the first channel layer 232. However, not limited thereto, other layers may be positioned between the first channel layer 232 and the first barrier layer 236. A region of the first channel layer 232 overlapping the first barrier layer 236 may be a drift region DTR. In other words, when a voltage higher than the threshold voltage is applied to the first gate electrode 255, a channel may be generated, between the first source electrode 273 and the first drain electrode 275, in a region of the first channel layer 232 which overlaps the first barrier layer 236 in the third direction D3.

The first barrier layer 236 may be simultaneously formed with the barrier layer 136 of the first high electron mobility transistor H1 in the same process. The first barrier layer 236 may include the same material as barrier layer 136. The first barrier layer 236 may include one or more materials selected from nitrides containing at least one of Group III-V materials, for example, Al, Ga, In, and B. The first barrier layer 236 may be AlₓIn_{y}Ga_{1-x-y}N (0≤x≤1, 0≤y≤1, x+y≤1). The first barrier layer 236 may include at least one of GaN, InN, AlGaN, AlInN, InGaN, AlN, AlInGaN, etc. The energy band gap of the first barrier layer 236 may be adjusted by the composition ratio of Al or In. The first barrier layer 236 may be doped with a predetermined impurity. At this time, the impurity doped in the first barrier layer 236 may be a P-type dopant capable of providing holes. For example, the impurity doped in the first barrier layer 236 may be magnesium (Mg). By increasing or decreasing the impurity doping concentration of the first barrier layer 236, the threshold voltage, on-resistance, and the like of the first transistor T1a according to one or more embodiments may be adjusted.

The first barrier layer 236 may include a semiconductor material with characteristics different from those of the first channel layer 232. The first barrier layer 236 may be different from the first channel layer 232 in at least one of polarization characteristic, energy band gap, and lattice constant. For example, the first barrier layer 236 may include a material having an energy band gap different from the first channel layer 232. At this time, the first barrier layer 236 may have an energy band gap higher than the first channel layer 232, and may have an electrical polarization higher than the first channel layer 232. The two-dimensional electron gas may be generated in a portion of the first channel layer 232, which is positioned below an interface between the first channel layer 232 and the first barrier layer 236.

The first gate electrode 255 may be positioned on the first barrier layer 236. The first gate electrode 255 may overlap some regions of the first barrier layer 236. The first gate electrode 255 may overlap a part of the drift region DTR of the first channel layer 232. The first gate electrode 255 may be positioned between the first source electrode 273 and the first drain electrode 275. The first gate electrode 255 may be spaced apart from the first source electrode 273 and the first drain electrode 275. The first gate electrode 255 may be extended along the second direction D2 on a plane. In other words, the first gate electrode 255 may have a shape of a bar extending along the second direction D2 on the plane.

The first gate electrode 255 may be simultaneously formed with the gate electrode 155 of the first high electron mobility transistor H1 in the same process. The first gate electrode 255 may include the same material as gate electrode 155. The first gate electrode 255 may contain conductive material. For example, the first gate electrode 255 may include metal, metal alloy, conductive metal nitride, metal silicide, doped semiconductor material, conductive metal oxide, or conductive metal nitride oxide. For example, the first gate electrode 255 may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride. (TiAlN), tantalum aluminum nitride(TaAlN), tungsten nitride(WN), ruthenium(Ru), titanium aluminum(TiAl), titanium aluminum carbonitride(TiAIC-N), titanium aluminum carbide(TiAlC), titanium carbide(TiC), tantalum carbonitride(TaCN), tungsten(W), aluminum(Al), copper(Cu), cobalt(Co), titanium(Ti), tantalum(Ta), nickel(Ni), platinum(Pt), nickel platinum(Ni) -Pt), niobium(Nb), niobium nitride(NbN), niobium carbide(NbC), molybdenum(Mo), molybdenum nitride(MoN), molybdenum carbide(MoC), tungsten carbide(WC), rhodium(Rh), palladium It may include (Pd), iridium (Ir), osmium (Os), silver (Ag), gold (Au), zinc (Zn), vanadium (V), or combinations thereof, but not limited thereto. The first gate electrode 255 may be made of a single layer or multiple layers.

The first transistor T1a according to one or more embodiments may further include a first gate semiconductor layer 252 positioned between the first barrier layer 236 and the first gate electrode 255. That is, the first gate semiconductor layer 252 may be positioned on the first barrier layer 236, and the first gate electrode 255 may be positioned on the first gate semiconductor layer 252. The first gate electrode 255 may be in Schottky contact with the first gate semiconductor layer 252. However, not limited thereto, in some cases, the first gate electrode 255 may be in ohmic contact with the first gate semiconductor layer 252. The first gate semiconductor layer 252 may overlap the first gate electrode 255. At this time, the first gate semiconductor layer 252 may completely overlap the first gate electrode 255 in the third direction D3. The top surface of the first gate semiconductor layer 252 may be entirely covered by the first gate electrode 255. That is, the first gate semiconductor layer 252 may have the substantially same planar shape as the first gate electrode 255.

The first gate semiconductor layer 252 may be positioned between the first source electrode 273 and the first drain electrode 275. The first gate semiconductor layer 252 may be spaced apart from the first source electrode 273 and the first drain electrode 275. The first gate semiconductor layer 252 may be positioned closer to the first source electrode 273 than to the first drain electrode 275. That is, a separation distance between the first gate semiconductor layer 252 and the first source electrode 273 may be smaller than a separation distance between the first gate semiconductor layer 252 and the first drain electrode 275.

The first gate semiconductor layer 252 may be simultaneously formed with gate semiconductor layer 152 in the same process. The first gate semiconductor layer 252 may include the same material as gate semiconductor layer 152. The first gate semiconductor layer 252 may include one or more materials selected from nitrides containing at least one of Group III-V materials, for example, Al, Ga, In, and B. The first gate semiconductor layer 252 may be AlₓIn_{y}Ga_{1-x-y}N (0≤x≤1, 0≤y≤1, x+y≤1). For example, the first gate semiconductor layer 252 may include at least one of AlN, GaN, InN, InGaN, AlGaN, AlInN, and AlInGaN. The first gate semiconductor layer 252 may include a material having an energy band gap different from the first barrier layer 236. For example, the first gate semiconductor layer 252 may include GaN, and the first barrier layer 236 may include AlGaN. The first gate semiconductor layer 252 may be doped with a predetermined impurity. At this time, the impurity doped in the first gate semiconductor layer 252 may be a P-type dopant capable of providing holes. For example, first gate semiconductor layer 252 may include GaN doped with P-type impurity. That is, the first gate semiconductor layer 252 may be made of a p-GaN layer. However, not limited thereto, the first gate semiconductor layer 252 may be a p-AlGaN layer. The impurity doped in the first gate semiconductor layer 252 may be magnesium (Mg). The first gate semiconductor layer 252 may be made of a single layer or multiple layers.

A depletion region DPR may be formed in the first gate semiconductor layer 252 by the gate semiconductor layer 152. As a depletion region DPR is generated, currents do not flow between the first source electrode 273 and the first drain electrode 275, and the channel path may be cut off. Accordingly, the first transistor T1a according to one or more embodiments may have a normally off characteristic. When a voltage higher than the threshold voltage is applied to the first gate electrode 255, the depletion region disappears, and two-dimensional electron gas 134 may be generated in the entire channel path between the first source electrode 273 and the first drain electrode 275.

The first transistor T1a according to one or more embodiments may be a normally on high electron mobility transistor. That is, in FIG. 10 to FIG. 13, the first gate semiconductor layer 252 may be omitted, and in this case, the depletion region may not be formed in the first channel layer 232. Accordingly, the first gate electrode 255 may be positioned directly on the first barrier layer 236. That is, the first gate electrode 255 may contact the first barrier layer 236.

The buffer layer 120, first channel layer 232, first barrier layer 236, and first gate semiconductor layer 252 described above may be sequentially stacked on the substrate 110. In the first transistor T1a according to one or more embodiments, at least one of the buffer layer 120, the first channel layer 232, the first barrier layer 236, and the first gate semiconductor layer 252 may be omitted. These buffer layer 120, the first channel layer 232, the first barrier layer 236, and the first gate semiconductor layer 252 may be made of semiconductor material with the same basis, and the composition ratio of each layer may be different, considering the role of each layer and the performance desired for the first transistor T1a.

The first source electrode 273 and the first drain electrode 275 may be positioned on the first channel layer 232. The first source electrode 273 and the first drain electrode 275 may be spaced apart from each other, and the first gate electrode 255 and the first gate semiconductor layer 252 may be positioned between the first source electrode 273 and the first drain electrode 275. The first gate electrode 255 and the first gate semiconductor layer 252 are separated from the first source electrode 273 and the first drain electrode 275. The first source electrode 273 may be electrically connected to the first channel layer 232 at a side of the first gate electrode 255. The first drain electrode 275 may be electrically connected to the first channel layer 232 at the other side of the first gate electrode 255.

In some regions of the first channel layer 232 between the first source electrode 273 and the first drain electrode 275, a drift region DTR as described with reference to FIG. 9 may be positioned. The first source electrode 273 and the first drain electrode 275 may be positioned outside the drift region of the first channel layer 232. In other words, the first source electrode 273 and the first drain electrode 275 are extended into the inside of the first channel layer 232, so that some regions of side surfaces may be in contact with the first channel layer 232. The drift region may be positioned between a portion of the side surface of the first source electrode 273 contacting the first channel layer 232 and a portion of the side surface of the first drain electrode 275 contacting the first channel layer 232. However, not limited thereto, the first source electrode 273 and the first drain electrode 275 may not be positioned outside the drift region DTR of the first channel layer 232. At this time, the first channel layer 232 may not be recessed, and the first source electrode 273 and the first drain electrode 275 may be positioned on the top surface of the first channel layer 232. Bottom surfaces of the first source electrode 273 and the first drain electrode 275 may be in contact with the top surface of the channel layer 132. A portion of the channel layer 132 in contact with the first source electrode 273 and the first drain electrode 275 may be doped at high concentration.

The first source electrode 273 and the first drain electrode 275 may extend along the second direction D2 in the plane formed by the first and second directions D1, D2, i.e., axis. That is, the first source electrode 273 and the first drain electrode 275 may have a shape of a bar extending along the second direction D2 on the plane formed by the first and second directions D1, D2, i.e., axis. The first source electrode 273 and the first drain electrode 275 may extend in parallel directions. The first source electrode 273 and the first drain electrode 275 may extend in a direction parallel to the first gate electrode 255. The first source electrode 273 may be electrically connected to the gate electrode 155 of the first high electron mobility transistor H1. That is, referring to FIG. 4 and FIG. 8, the first source electrode 273 of the first transistor T1a may be connected to the gate electrode 155 of the first high electron mobility transistor H1 at the output node N1. As shown in FIG. 8, the first source electrode 273 and the gate electrode 155 may be electrically connected to each other by the first contact hole CH1 formed outside the first amplification circuit AMP1 and the first high electron mobility transistor H1 in the thickness direction.

The first source electrode 273 and the first drain electrode 275 may be simultaneously formed with the lower source electrode 173a and the lower drain electrode 175a in the same process. The first source electrode 273 and the first drain electrode 275 may include the same material as the lower source electrode 173a of the first high electron mobility transistor H1. The first source electrode 273 and the first drain electrode 275 may include conductive material. For example, the first source electrode 273 and the first drain electrode 275 may include metal, metal alloy, conductive metal nitride, metal silicide, doped semiconductor material, conductive metal oxide, or conductive metal nitride oxide. For example, the first source electrode 273 and the first drain electrode 275 may include titanium nitride (TiN), tantalum carbide (TaC), tantalum nitride (TaN), titanium silicon nitride (TiSiN), tantalum silicon nitride (TaSiN), tantalum titanium nitride (TaTiN). , titanium aluminum nitride(TiAIN), tantalum aluminum nitride(TaAIN), tungsten nitride(WN), ruthenium(Ru), titanium aluminum(TiAl), titanium aluminum carbonitride(TiAIC-N), titanium aluminum carbide(TiAlC), titanium carbide (TiC), tantalum carbonitride(TaCN), tungsten(W), aluminum(Al), copper(Cu), cobalt(Co), titanium(Ti), tantalum(Ta), nickel(Ni), platinum(Pt), nickel platinum(Ni-Pt), niobium(Nb), niobium nitride(NbN), niobium carbide(NbC), molybdenum(Mo), molybdenum nitride(MoN), molybdenum carbide(MoC), tungsten carbide(WC), rhodium( Rh), palladium (Pd), iridium (Ir), osmium (Os), silver (Ag), gold (Au), zinc (Zn), vanadium (V), or combinations thereof, but limited thereto. The first source electrode 273 and the first drain electrode 275 may be made of a single layer or multiple layers. The first source electrode 273 and the first drain electrode 275 may be in ohmic contact with the first channel layer 232. A region in contact with the first source electrode 273 and the first drain electrode 275 in the first channel layer 232 may be doped at a relatively high concentration compared to other regions.

The second transistor T1b may be positioned at a side of the first transistor T1a. The second transistor T1b may include a second channel layer 332, a second barrier layer 336 positioned on the second channel layer 332, a second gate electrode 355 positioned on the second barrier layer 336, and a second source electrode 373 and a second drain electrode 375 positioned at both sides (i.e. on opposite sides) of the second gate electrode 355.

The second channel layer 332 may be a layer that forms a channel between the second source electrode 373 and the second drain electrode 375. In the second channel layer 332, a two-dimensional electron gas 134 as described with reference to FIG. 9 may be positioned. Two-dimensional electron gas may be generated at the interface between the second channel layer 332 and the second barrier layer 336. For example, two-dimensional electron gas 134 may be generated, in the second channel layer 332, at a portion closest to the second barrier layer 336.

The second channel layer 332 may be positioned at the same layer as the channel layer 132 (see Fig. 9) of the first high electron mobility transistor H1 and the first channel layer 232. The second channel layer 332 may include the same material as the first channel layer 232 and the channel layer 132 of the first high electron mobility transistor H1 and may be formed in the same process. The second channel layer 332 may be an impurity doped layer or an impurity undoped layer. The thickness of the second channel layer 332 may be approximately several hundred nm or less.

The second channel layer 332 may be positioned on the substrate 110, and a seed layer 115, a buffer layer 120, and the like may be positioned between the substrate 110 and the second channel layer 332. That is, the second channel layer 332 may be simultaneously formed with the channel layer 132 of the first high electron mobility transistor H1 and the first channel layer 232 on the same substrate 110, using the same process. That is, after forming the seed layer 115 and the buffer layer 120 on the substrate 110, the channel layer 132, the first channel layer 232 and the second channel layer 332 may be simultaneously formed on the buffer layer 120. The channel layer 132 and the second channel layer 332 may be positioned apart from each other in the second direction D2. The channel layer 132 and second channel layer 332 may be separated from each other by a separation pattern IP shown in FIG. 8. The positions of the channel layer 132 and the second channel layer 332 on the substrate 110 may be defined by the separation pattern IP. The separation pattern IP may be positioned between the channel layer 132 and the second channel layer 332. The channel layer 132 and the second channel layer 332 spaced apart from each other may be formed by the separation pattern IP. The separation pattern IP may be positioned between the first channel layer 232 and the second channel layer 332. The second channel layer 332 may be formed integrally with the first channel layer 232, and thus, the boundary between the second channel layer 332 and the first channel layer 232 may not be recognized.

The second barrier layer 336 may be positioned on the second channel layer 332. The second barrier layer 336 may be positioned directly on the second channel layer 332. However, not limited thereto, and other layers may be positioned between the second channel layer 332 and the second barrier layer 336. A region of the second channel layer 332 overlapping the second barrier layer 336 may be a drift region DTR described with reference to FIG. 8. In other words, when a voltage higher than the threshold voltage is applied to the second gate electrode 355, a channel may be generated in a region, between the second source electrode 373 and the second drain electrode 375, of the second channel layer 332 which overlaps the second barrier layer 336 in the third direction D3.

The second barrier layer 336 may be simultaneously formed with barrier layer 136 in the same process. The second barrier layer 336 may include the same material as barrier layer 136.

The second barrier layer 336 may include a semiconductor material with characteristics different from those of the second channel layer 332. The second barrier layer 336 may be different from the second channel layer 332 in at least one of polarization characteristic, energy band gap, and lattice constant. For example, the second barrier layer 336 may include a material having an energy band gap different from the second channel layer 332. At this time, the second barrier layer 336 may have an energy band gap higher than the second channel layer 332 and may have an electrical polarization higher than the second channel layer 332. The two-dimensional electron gas may be generated in a portion of the second channel layer 332, which is positioned below an interface between the second channel layer 332 and the second barrier layer 336.

The second gate electrode 355 may be positioned on the second barrier layer 336. The first gate electrode 255 may overlap some regions of the second barrier layer 336. The second gate electrode 355 may overlap a part of the drift region DTR of the second channel layer 332. The second gate electrode 355 may be positioned between the second source electrode 373 and the second drain electrode 375. The second gate electrode 355 may be spaced apart from the second source electrode 373 and the second drain electrode 375. The second gate electrode 355 may be extended along the second direction D2 on a plane. In other words, the second gate electrode 355 may have a shape of a bar extending along the second direction D2 on the plane.

The second gate electrode 355 may be simultaneously formed with the first gate electrode 255 and the gate electrode 155 described with reference to FIG. 9 in the same process. The second gate electrode 355 may include the same material as the gate electrode 155 and the first gate electrode 255. The second gate electrode 355 may be made of a single layer or multiple layers.

The second transistor T1b according to the embodiment may further include a second gate semiconductor layer 352 positioned between the second barrier layer 336 and the second gate electrode 355. That is, the second gate semiconductor layer 352 may be positioned on the second barrier layer 336, and the second gate electrode 355 may be positioned on the second gate semiconductor layer 352. The second gate electrode 355 may be in Schottky contact with second gate semiconductor layer 352. However, not limited thereto, in some cases, the second gate electrode 355 may be in ohmic contact with the second gate semiconductor layer 352. The second gate semiconductor layer 352 may overlap the second gate electrode 355. At this time, the second gate semiconductor layer 352 may completely overlap the second gate electrode 355 in a third direction D3. The top surface of the second gate semiconductor layer 352 may be entirely covered by the second gate electrode 355. That is, the second gate semiconductor layer 352 may have the substantially same planar shape as the second gate electrode 355.

The second gate semiconductor layer 352 may be positioned between the second source electrode 373 and the second drain electrode 375. The second gate semiconductor layer 352 may be spaced apart from the second source electrode 373 and the second drain electrode 375. The second gate semiconductor layer 352 may be positioned closer to the second source electrode 373 than to the second drain electrode 375. That is, a separation distance between the second gate semiconductor layer 352 and the second source electrode 373 may be smaller than a separation distance between the second gate semiconductor layer 352 and the second drain electrode 375.

The second gate semiconductor layer 352 may be simultaneously formed with the gate semiconductor layer 152 and first gate semiconductor layer 252 in the same process. The second gate semiconductor layer 352 may include the same material as gate semiconductor layer 152 and first gate semiconductor layer 252. The second gate semiconductor layer 352 may be made of a single layer or multiple layers.

A depletion region DPR may be generated in the second channel layer 332 by the second gate semiconductor layer 352. As a depletion region DPR is generated, currents do not flow between the second source electrode 373 and the second drain electrode 375, and the channel path may be cut off. Accordingly, the second transistor T1b according to one or more embodiments may have a normally off characteristic. When a voltage higher than the threshold voltage is applied to the second gate electrode 355, the depletion region disappears, and the two-dimensional electron gas 134 may be generated in the entire channel path between the second source electrode 373 and the second drain electrode 375.

The second transistor T1b according to one or more embodiments may be a normally on high electron mobility transistor. That is, in FIG. 10 to FIG. 13, the second gate semiconductor layer 352 may be omitted, and in this case, the depletion region may not be formed in the second channel layer 332. Accordingly, the second gate electrode 355 may be positioned directly on the second barrier layer 336. That is, the second gate electrode 355 may contact the second barrier layer 336.

The buffer layer 120, the second channel layer 332, the second barrier layer 336, and second gate semiconductor layer 352 described above may be sequentially stacked on the substrate 110. In the second transistor T1b according to one or more embodiments, at least one of the buffer layer 120, the second channel layer 332, the second barrier layer 336, and the second gate semiconductor layer 352 may be omitted. These buffer layer 120, the second channel layer 332, the second barrier layer 336, and the second gate semiconductor layer 352 may be made of semiconductor material with the same basis, and the composition ratios of each layer may be different, considering the role of each layer and the performance desired for the high electron mobility transistor.

The second source electrode 373 and the second drain electrode 375 may be positioned on the second channel layer 332. The second source electrode 373 and the second drain electrode 375 may be spaced apart from each other, and the second gate electrode 355 and the second gate semiconductor layer 352 may be positioned between the second source electrode 373 and the second drain electrode 375. The second gate electrode 355 and the second gate semiconductor layer 352 are separated from the second source electrode 373 and the second drain electrode 375. The second source electrode 373 may be electrically connected to the second channel layer 332 at a side of the second gate electrode 355. The second drain electrode 375 may be electrically connected to the second channel layer 332 at the other side of the second gate electrode 355.

In some regions of the second channel layer 332 between the second source electrode 373 and the second drain electrode 375, a drift region DTR may be positioned. The second source electrode 373 and the second drain electrode 375 may be positioned outside the drift region of the second channel layer 332. That is, the second source electrode 373 and the second drain electrode 375 are extended into the inside of the second channel layer 332, so that some regions of side surfaces may be in contact with the second channel layer 332. The drift region may be positioned between a portion of the side surface of the second source electrode 373 in contact with the second channel layer 332 and a portion of the side of the second drain electrode 375 in contact with the second channel layer 332. However, not limited thereto, the second source electrode 373 and the second drain electrode 375 may not be positioned outside the drift region DTR of the second channel layer 332. At this time, the second channel layer 332 may not be recessed, and the second source electrode 373 and the second drain electrode 375 may be positioned on the top surface of the second channel layer 332. The bottom surfaces of the second source electrode 373 and the second drain electrode 375 may be in contact with the top surface of the channel layer 132. A portion of the channel layer 132 in contact with the second source electrode 373 and the second drain electrode 375 may be doped at high concentration.

The second source electrode 373 and the second drain electrode 375 may extend along the second direction D2 in the plane formed by the second and first directions D2, D1, i.e., axis. That is, the second source electrode 373 and the second drain electrode 375 may have a shape of a bar extending long along the second direction D2 on the plane formed by the second and first directions D2, D1, i.e., axis. The second source electrode 373 and the second drain electrode 375 may extend in parallel directions. The second source electrode 373 and the second drain electrode 375 may extend in a direction parallel to the second gate electrode 355.

The second drain electrode 375 may be electrically connected to the first source electrode 273 and the gate electrode 155 of the first high electron mobility transistor H1. That is, referring to FIG. 4 and FIG. 8, the second drain electrode 375 of the second transistor T1b may be connected to the first source electrode 273 of the first transistor T1a and the gate electrode 155 of the first high electron mobility transistor H1, at the output node N1. As shown in FIG. 8, the second drain electrode 375 and the gate electrode 155 may be electrically connected to each other by the first contact hole CH1 formed in the thickness direction, outside the first amplification circuit (amplifier) AMP1 and the first high electron mobility transistor H1.

The second drain electrode 375 of the second transistor T1b and the first source electrode 273 of the first transistor T1a may be in contact with each other in the first direction D1. One side surface of the second drain electrode 375 may be in contact with one side surface of the first source electrode 273. In one or more embodiments, the second drain electrode 375 of the second transistor T1b and the first source electrode 273 of the first transistor T1a may be formed integrally, and the boundary between them may not be recognized.

The second source electrode 373 and the second drain electrode 375 may be simultaneously formed with the first source electrode 273, first drain electrode 275, lower source electrode 173a, and lower drain electrode 175a in the same process. The second source electrode 373 and the second drain electrode 375 may include the same material as the first source electrode 273, the first drain electrode 275, the lower source electrode 173a, and the lower drain electrode 175a. The second source electrode 373 and second drain electrode 375 may be made of a single layer or multiple layers. The second source electrode 373 and the second drain electrode 375 may be in ohmic contact with the second channel layer 332. A region in contact with the second source electrode 373 and the second drain electrode 375 in the second channel layer 332 may be doped at a relatively high concentration compared to other regions.

The capacitor C1 may be positioned at the other side of the first transistor T1a. In the embodiment, the capacitor C1 may include a first capacitor semiconductor pattern 432, a first dielectric material 436 positioned on the first capacitor semiconductor pattern 432, a first capacitor electrode 453 positioned on the first dielectric material 436, a second dielectric material 455 positioned on the first capacitor electrode 453, and a second capacitor electrode 457 positioned on the second dielectric material 455.

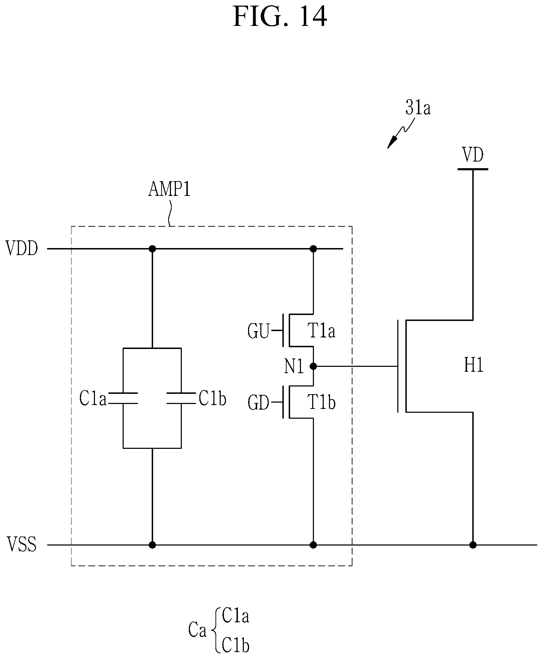

In one or more embodiments, the capacitor C1 may include two sub-capacitors. For example, referring to FIG. 14, the capacitor C1 may include a first capacitor C1a and a second capacitor C1b coupled in parallel with each other. In FIG. 10 to FIG. 13, a first capacitor semiconductor pattern 432, a first dielectric material 436, and a first capacitor electrode 453 may form the first capacitor C1a shown in FIG. 14, and a first capacitor electrode 453, a second dielectric material 455, and a second capacitor electrode 457 may form the second capacitor C1b shown in FIG. 14. In some embodiments, the capacitor C1 may include only any one of the first and second capacitors C1a and C1b. In some embodiments, any one of the first and second capacitors C1a and C1b may be omitted.

In one or more embodiments, the first capacitor electrode 453 may be a common electrode of the first capacitor C1a and the second capacitor C1b. In other words, the first capacitor electrode 453 may be the first electrode of the first capacitor C1a and simultaneously the first electrode of the second capacitor C1b. In the embodiment, the first capacitor electrode 453 may be connected to a first power voltage VDD (see Fig. 4 and Fig. 14) through the first power line VL1 which will be described later.

The first capacitor C1a according to the embodiment may have a MIS (Metal-Insulator-Semiconductor) structure. That is, the capacitor according to the embodiment may have a structure in which an insulating layer is disposed between a semiconductor layer and a metal layer. Referring to FIG. 10 to FIG. 13, the first capacitor C1a according to the embodiment may include a first capacitor electrode 453, a first capacitor semiconductor pattern 432 positioned below the first capacitor electrode 453 and overlapping the first capacitor electrode 453 in the third direction D3, and a first dielectric material 436 positioned between the first capacitor electrode 453 and first capacitor semiconductor pattern 432 and overlapping the first capacitor semiconductor pattern 432 in the third direction D3.

The first capacitor semiconductor pattern 432 may be a semiconductor layer in the MIS structure. Two-dimensional electron gas 134 may be positioned in the first capacitor semiconductor pattern 432. In other words, when a voltage level higher than the threshold voltage is applied to the first capacitor electrode 453, two-dimensional electron gas may be generated at an interface of the first capacitor semiconductor pattern 432 and the first dielectric material 436. The first capacitor semiconductor pattern 432 may be connected to a second power line VL2, which will be described later, through conductive pattern 459 that will be described later. The first capacitor semiconductor pattern 432 may be connected to the second power line VL2 through a conductive pattern 459 which will be described later.

The first capacitor semiconductor pattern 432 may include semiconductor material. In the embodiment, the first capacitor semiconductor pattern 432 may include the same material as the first channel layer 232 and the second channel layer 332. The thickness of the first capacitor semiconductor pattern 432 may be approximately several hundred nm or less.

The first capacitor semiconductor pattern 432 may be positioned on the substrate 110, and the seed layer 115, the buffer layer 120 and the like may be positioned between the substrate 110 and the first capacitor semiconductor pattern 432. That is, the first capacitor semiconductor pattern 432 may be simultaneously formed with the channel layer 132, first channel layer 232, and second channel layer 332 of the first high electron mobility transistor H1 on the same substrate 110, using the same process. That is, after forming the seed layer 115 and the buffer layer 120 on the substrate 110, the channel layer 132, the first channel layer 232, the second channel layer 332, and the first capacitor semiconductor pattern 432 may be simultaneously formed on the buffer layer 120.

The first capacitor semiconductor pattern 432 may be positioned spaced from the channel layer 132 in the second direction D2. The first capacitor semiconductor pattern 432 may be separated from the channel layer 132 each other by the separation pattern IP shown in FIG. 8. The separation pattern IP may have a bottom surface lower than bottom surfaces of the channel layer 132 and the first capacitor semiconductor pattern 432. That is, the separation pattern IP is positioned between the channel layer 132 and the first capacitor semiconductor pattern 432 to electrically separate the channel layer 132 and the first capacitor semiconductor each other. The separation pattern IP may include, for example, Ar. The separation pattern IP may not be positioned between the first capacitor semiconductor pattern 432 and the first channel layer 232. The first capacitor semiconductor pattern 432 may be formed integrally with the first channel layer 232 and the second channel layer 332, and thus, the boundary of the first capacitor semiconductor pattern 432 with the first channel layer 232 and the second channel layer 332 may not be recognized.

The first dielectric material 436 may be an insulating layer in the MIS structure. The first dielectric material 436 may be positioned on the first capacitor semiconductor pattern 432. The first dielectric material 436 may be positioned directly on the first capacitor semiconductor pattern 432. However, not limited thereto, other layers may be further positioned between the first dielectric material 436 and the first capacitor semiconductor pattern 432. The first dielectric material 436 may have a bottom surface in contact with the top surface of the first capacitor semiconductor pattern 432. The first dielectric material 436 may be positioned between the first capacitor semiconductor pattern 432 and the first capacitor electrode 453.

The first dielectric material 436 may be simultaneously formed with the first barrier layer 236 and the second barrier layer 336 in the same process. The first dielectric material 436 may include the same material as the first barrier layer 236 and the second barrier layer 336. The energy band gap of first dielectric material 436 may be controlled by the composition ratio of Al or In. The first dielectric material 436 may include a semiconductor material having characteristics different from the first capacitor semiconductor pattern 432. The first dielectric material 436 may be different from the first capacitor semiconductor pattern 432 in at least one of polarization characteristic, energy band gap, and lattice constant. For example, the first dielectric material 436 may include a material having an energy band gap different from the first capacitor semiconductor pattern 432. At this time, the first dielectric material 436 may have an energy band gap higher than the first capacitor semiconductor pattern 432 and may have an electrical polarization higher than the first capacitor semiconductor pattern 432. A two-dimensional electron gas may be formed at a portion of the first capacitor semiconductor pattern 432, which is positioned below an interface between the first capacitor semiconductor pattern 432 and the first dielectric material 436.

The first capacitor electrode 453 may be a metal layer in the MIS structure. The first capacitor electrode 453 may be positioned on the first dielectric material 436. The first capacitor electrode 453 may be connected to the first power line VL1, which will be described later, to receive a voltage from the first power voltage VDD. In one or more embodiments, the width of the first capacitor electrode 453 along the first direction D1 may be smaller than the width of the first dielectric material 436 along the first direction D1. The first capacitor electrode 453 may be extended along the second direction D2 on a plane. In other words, the first capacitor electrode 453 may have a shape of a bar extending along the second direction D2 on the plane. The first capacitor electrode 453 may extend in a direction parallel to the first source electrode 273, first drain electrode 275, second source electrode 373, second drain electrode 375, first gate electrode 255, and second gate electrode 355.

The first capacitor electrode 453 may be simultaneously formed with the first gate electrode 255 and the first capacitor electrode 453 in the same process. The first capacitor electrode 453 may include the same material as the first gate electrode 255 and the first capacitor electrode 453. The first capacitor electrode 453 may be made of a single layer or multiple layers.

The capacitor C1 according to the embodiment may further include a second capacitor semiconductor pattern 451 positioned between the first capacitor electrode 453 and the first dielectric material 436. The second capacitor semiconductor pattern 451 may have a top surface in contact with the bottom surface of the first capacitor electrode 453 and a bottom surface in contact with the top surface of the first dielectric material 436. The second capacitor semiconductor pattern 451 may completely overlap the first capacitor electrode 453 and the third direction D3. The top surface of the second capacitor semiconductor pattern 451 may be entirely covered by the first capacitor electrode 453. The second capacitor semiconductor pattern 451 may have the substantially same planar shape as the first capacitor electrode 453. In one or more embodiments, the second capacitor semiconductor pattern 451 and the first capacitor electrode 453 may perform the same or similar function as the metal layer in the MIS structure.

In one or more embodiments, second capacitor semiconductor pattern 451 may be simultaneously formed with first gate semiconductor layer 252 and second gate semiconductor layer 352 in the same process. The second capacitor semiconductor pattern 451 may include the same material as the first gate semiconductor layer 252 and the second gate semiconductor layer 352. The second capacitor semiconductor pattern 451 can be doped to a predetermined impurity. At this time, the impurity doped in the second capacitor semiconductor pattern 451 may be a P-type dopant. For example, second capacitor semiconductor pattern 451 may include GaN doped with P-type impurity. That is, the second capacitor semiconductor pattern 451 may be made of a p-GaN layer. The impurity doped in the second capacitor semiconductor pattern 451 may be magnesium (Mg).

The second capacitor C1b according to the embodiment may have a Metal-Insulator-Metal (MIM) structure. In other words, the second capacitor C1b according to the embodiment may have a structure in which an insulating layer is disposed between two metal layers. Referring FIG. 10 to FIG. 13, the second capacitor C1b may include a first capacitor electrode 453, a second capacitor electrode 457 positioned on the first capacitor electrode 453 and overlapping the first capacitor electrode 453 in the third direction D3, and a second dielectric material 455 positioned between the first capacitor electrode 453 and the second capacitor electrode 457 and overlapping the second capacitor electrode 457 in the third direction D3.

The second dielectric material 455 may be positioned above the first capacitor electrode 453. The second dielectric material 455 may have a bottom surface in contact with the top surface of the first capacitor electrode 453 and a top surface in contact with the bottom surface of the second capacitor electrode 457. A width of the second dielectric material 455 along the first direction D1 may be smaller than a width of the first capacitor electrode 453 along the first direction D1. A width of the second dielectric material 455 along the second direction D2 may be substantially same as a width of the first capacitor electrode 453 along the second direction D2. Referring to FIG. 10 to FIG. 13, the second dielectric material 455 may be positioned biasedly to one side on the top surface of the first capacitor electrode 453. In one or more embodiments, one side surface of the second dielectric material 455 may be aligned with one side surface of the first capacitor electrode 453 on the same plane. However, not limited thereto, the second dielectric material 455 may be placed in a center of the top surface of the first capacitor electrode 453. The second dielectric material 455 may extend in the second direction D2 on a plane. The second dielectric material 455 may have a shape of a bar extending long in the second direction D2 on the plane. The second dielectric material 455 may be arranged in parallel with the first source electrode 273, first drain electrode 275, first gate electrode 255, second source electrode 373, second drain electrode 375, and second gate electrode 355 on a plane.

The second dielectric material 455 may include an insulating material. In one or more embodiments, the second dielectric material 455 may be SiNx. However, not limited thereto, the second dielectric material 455 may include various types of insulating materials capable of insulating between the second capacitor electrode 457 and the first capacitor electrode 453. For example, the second dielectric material 455 may include an insulating material such as SiO2, Al2O3, SiN, SiON, or a combination thereof. The second dielectric material 455 may include the same material as the protective layers 140, and 160 described with reference to FIG. 9, or may include a different material.

The second capacitor electrode 457 may be positioned on the second dielectric material 455. The second capacitor electrode 457 can be positioned directly on the second dielectric material 455. However, not limited thereto, another layers may be positioned between the second capacitor electrode 457 and the second dielectric material 455. A width of the second capacitor electrode 457 along the first direction D1 may be smaller than a width of the first capacitor electrode 453 along the first direction D1. A width of the second capacitor electrode 457 along the second direction D2 may be substantially same as a width of the first capacitor electrode 453 along the second direction D2. The top surface of the second capacitor electrode 457 may be covered by the second dielectric material 455. Referring to FIG. 10 to FIG. 13, the second capacitor electrode 457 may completely overlap the second dielectric material 455 in the third direction D3. In other words, the second capacitor electrode 457 may have the substantially same planar shape as the second dielectric material 455. The second capacitor electrode 457 may extend in the second direction D2 on a plane. The second capacitor electrode 457 may have a shape of a bar extending long in the second direction D2 on the plane.

The second capacitor electrode 457 may contain conductive material. For example, the second capacitor electrode 457 may include metal, metal alloy, conductive metal nitride, metal silicide, doped semiconductor material, conductive metal oxide, or conductive metal nitride oxide. For example, the second capacitor electrode 457 may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride. (TiAlN), tantalum aluminum nitride(TaAIN), tungsten nitride(WN), ruthenium(Ru), titanium aluminum(TiAl), titanium aluminum carbonitride(TiAIC-N), titanium aluminum carbide(TiAlC), titanium carbide(TiC), tantalum carbonitride(TaCN), tungsten(W), aluminum(Al), copper(Cu), cobalt(Co), titanium(Ti), tantalum(Ta), nickel(Ni), platinum(Pt), nickel platinum(Ni) -Pt), niobium(Nb), niobium nitride(NbN), niobium carbide(NbC), molybdenum(Mo), molybdenum nitride(MoN), molybdenum carbide(MoC), tungsten carbide(WC), rhodium(Rh), palladium It may include (Pd), iridium (Ir), osmium (Os), silver (Ag), gold (Au), zinc (Zn), vanadium (V), or combinations thereof, but not limited thereto. The second capacitor electrode 457 may be made of a single layer or multiple layers.

The first amplification circuit AMP1 according to one or more embodiments may further include a conductive pattern 459 positioned at a side of capacitor C1. The conductive pattern 459 may connect the first capacitor semiconductor pattern 432 with the second power line VL2 which will be described later. In other words, the conductive pattern 459 is positioned between the first capacitor semiconductor pattern 432 and the second power line VL2, and may electrically connect the first capacitor semiconductor pattern 432 and the second power line VL2. The conductive pattern 459 may be extended in the third direction D3. Referring to FIG. 13, the conductive pattern 459 may have a top surface in contact with some regions of the second power line VL2 which will be described later. The conductive pattern 459 is extended to the inside of the first capacitor semiconductor pattern 432, so that some regions of the side surface and the bottom surface may be in contact with the first capacitor semiconductor pattern 432. Some regions of the side surface of conductive pattern 459 may also be in contact with the first dielectric material 436.

The conductive pattern 459 may contain conductive material. In one or more embodiments, conductive pattern 459 may be simultaneously formed with the first and second source electrodes 273 and 373 and the first and second drain electrodes 275 and 375 in the same process. The conductive pattern 459 may include the same material as the first and second source electrodes 273 and 373 and the first and second drain electrodes 275 and 375. The conductive pattern 459 may be made of a single layer or multiple layers.

The first transistor T1a, second transistor T1b and capacitor C1 may be covered by the first protective layer 140 or the second protective layer 160 described with reference to FIG. 9.

Referring to FIG. 10 to FIG. 13, the first protective layer 140 may cover the lower and side surfaces of the first gate electrode 255 and the second gate electrode 355. The first protective layer 140 may cover the side surfaces of the first gate semiconductor layer 252 and the second gate semiconductor layer 352. The first protective layer 140 may cover a portion of the top surfaces of the first barrier layer 236 and the second barrier layer 336. The first protective layer 140 may contact the side surfaces of the first and second source electrodes 273, and 373 and the first and second drain electrodes 275, and 375. The top surface of the first protective layer 140 may be in contact with the second protective layer 160.

Referring to FIG. 10 to FIG. 13, the first protective layer 140 may cover the side surface and some regions of the top surface of the second capacitor semiconductor pattern 451. The first protective layer 140 may cover the side surface of the second capacitor semiconductor pattern 451. The first protective layer 140 may cover some regions of the top surface of the first dielectric material 436. The first protective layer 140 may cover the side surface and some regions of the top surface of the second capacitor electrode 457. The first protective layer 140 may cover the side surface of the second dielectric material 455. The first protective layer 140 may cover some regions of the top surface of the first dielectric material 436. The first protective layer 140 may be in contact with one side surface of the conductive pattern 459.

The second protective layer 160 may be positioned on the first protective layer 140. The second protective layer 160 may contact at least some portions of the top surfaces of the first and second source electrodes 273 and 373 and the first and second drain electrodes 275 and 375. The second protective layer 160 may have a bottom surface in contact with the top surface of the first protective layer 140.

The first amplification circuit AMP1 according to one or more embodiments may further include power lines VL1 and VL2 and signal lines GL1 and GL2 positioned above the second protective layer 160. The power lines VL1 and VL2 and signal lines GL1 and GL2, respectively, may provide an electrical signal to at least one of the electrodes and conduction patterns 273, 275, 373, 375, 453, 457, 459 included in the first transistor T1a, second transistor T1b and capacitor C1. The capacitor C1 may be spaced apart from the first and second transistors T1a, T1b and may not overlap any of the first and second power lines VL1, VL2 and first and second signal lines GL1, GL2 in the third direction D3. In other words, the capacitor C1 may be non-overlapping in respect of the first and second power lines VL1, VL2 and first and second signal lines GL1, GL2 in the third direction D3.

Referring to FIG. 7 and FIG. 8, the power lines VL1 and VL2 and signal lines GL1 and GL2 may be arranged to be spaced apart in the second direction D2 and may extend along the first direction D1. The power lines VL1 and VL2 and signal lines GL1 and GL2 may respectively provide electrical signals to a plurality of amplification circuits AMP1 to AMP4 arranged in the first direction D1.

The first power line VL1 may be connected to the first power voltage VDD (see Fig. 4). Referring to FIG. 4, FIG. 8 and FIG. 10, the first power line VL1 may be connected to the first drain electrode 275 and the first capacitor electrode 453 through the contact holes CH2 and CH3 formed in the second protective layer 160 or first protective layer 140, respectively. Specifically, the first power line VL1 may be connected to the first drain electrode 275 of the first transistor T1a through the second contact hole CH2. The first power line VL1 may be connected to the first capacitor electrode 453 of capacitor C1 through the third contact hole CH3. The first drain electrode 275 and the first capacitor electrode 453 may receive the first power voltage VDD through the first power line VL1.

The second power line VL2 may be connected to the second power voltage VSS (see Fig. 4). Referring to FIG. 4, FIG. 8 and FIG. 13, the second power line VL2 may be connected to the second source electrode 373, the second capacitor electrode 457, and the conductive pattern 459 through contact holes CH4, CH5, and CH6 formed in the second protective layer 160 or first protective layer 140, respectively. Specifically, the second power line VL2 may be connected to the second source electrode 373 of the second transistor T1b through the fourth contact hole CH4. The second power line VL2 may be connected to the second capacitor electrode 457 of capacitor C1 through the fifth contact hole CH5. The second power line VL2 may be connected to conductive pattern 459 through the sixth contact hole CH6. The second source electrode 373, second capacitor electrode 457, and conductive pattern 459 may receive the second power voltage VSS through the second power line VL2. In some embodiments, the second power supply voltage VSS may have a voltage level substantially same as the ground voltage.

The first signal line GL1 may be connected to one terminal of the signal generator 21 (see Fig. 3) from which the pull-up signal GU (see Fig. 3) is output. Referring to FIG. 4, FIG. 8 and FIG. 11, the first signal line GL1 may be connected to the first gate electrode 255 through the seventh contact hole formed in the second protective layer 160 and the first protective layer 140. Specifically, the first signal line GL1 may be connected to the first gate electrode 255 of the first transistor T1a through the seventh contact hole CH7. The first gate electrode 255 may receive a pull-up signal GU from the signal generator 21 (see Fig. 3) through the first signal line GL1.

The second signal line GL2 may be connected to one terminal of the signal generator 21 (see Fig. 3) from which the pull-down signal GD (see Fig. 3) is output. In some embodiments, the terminal from which the pull-down signal GD (see Fig. 3) is output may be a terminal different from the terminal from which the pull-up signal GU is output. Referring to FIG. 4, FIG. 8 and FIG. 12, the second signal line GL2 may be connected to the second gate electrode 355 through the eighth contact hole CH8 formed in the second protective layer 160 and the first protective layer 140. Specifically, the second signal line GL2 may be connected to the second gate electrode 355 of the second transistor T1b through the eighth contact hole CH8. The second gate electrode 355 may receive a pull-down signal GD from the signal generator 21 (see Fig. 3) through the second signal line GL2.

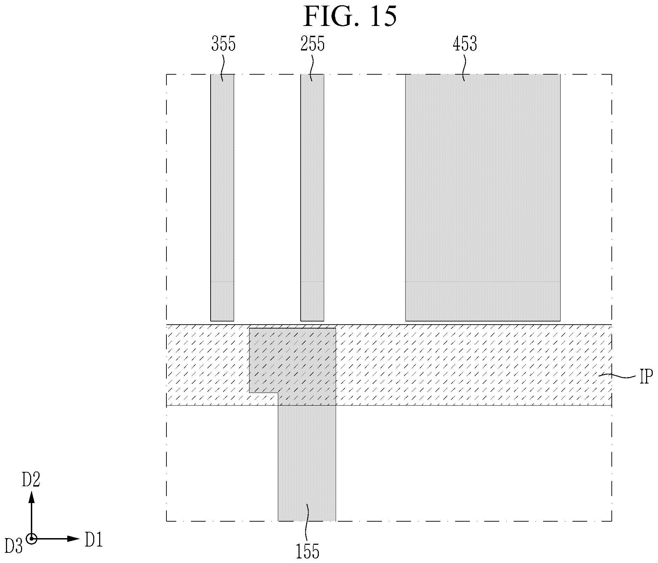

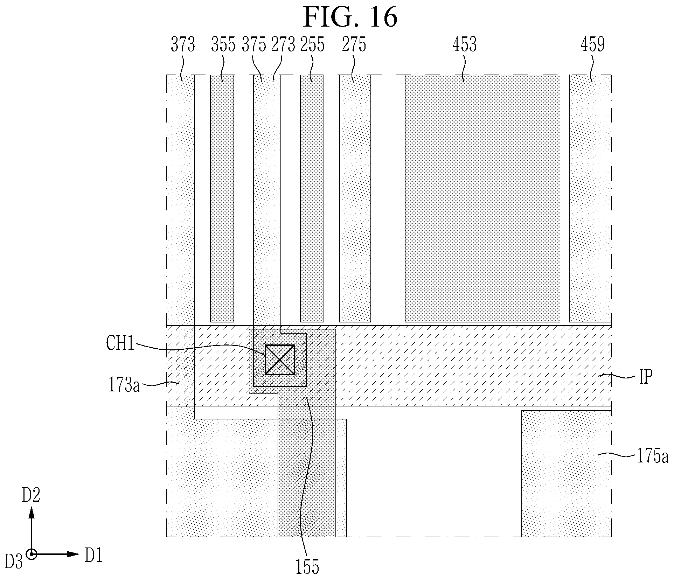

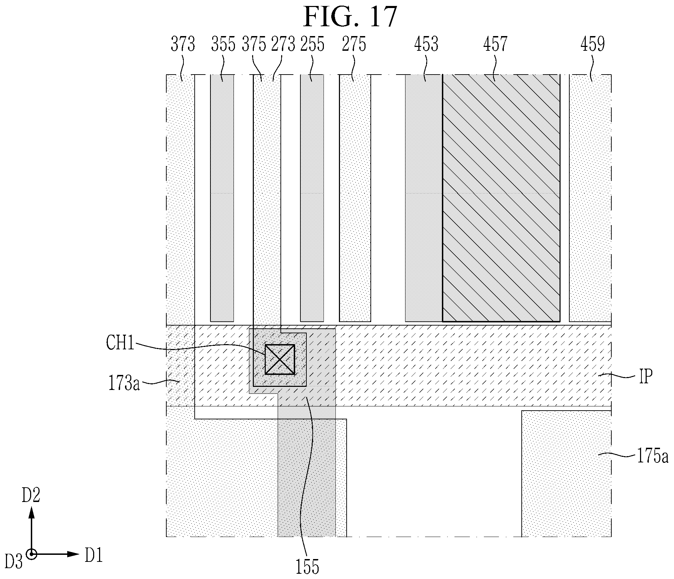

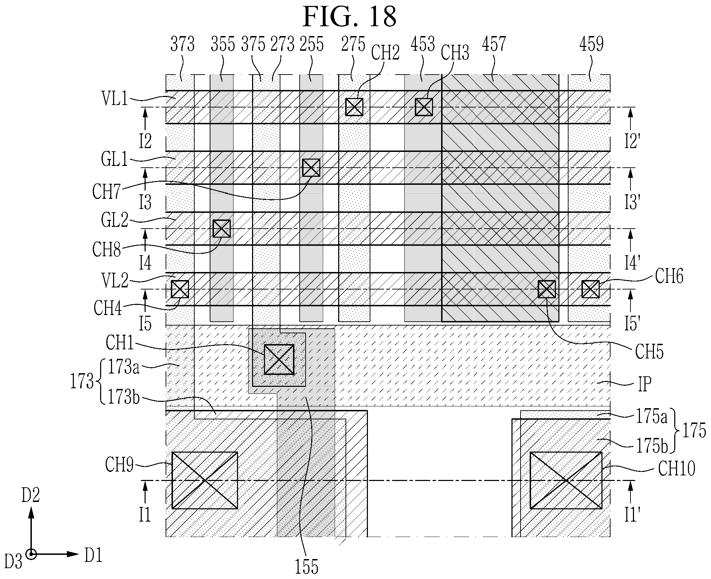

FIGS. 15 to 18 are top plan views of a semiconductor device according to one or more embodiments. Specifically, FIG. 15 to FIG. 18 are drawings illustrating that the electrodes 155, 173, and 175 of the first high electron mobility transistor H1 and the electrodes and conduction patterns (273, 275, 373, 375, 453, 457, 459) of the first amplification circuit AMP1 are sequentially overlapped according to the process order. Specifically, FIG. 15 may illustrate electrodes positioned on a first layer positioned at the lowest. FIG. 16 may illustrate the first layer, and electrodes positioned on a second layer on the first layer. FIG. 17 may illustrate the first layer, second layer and electrodes positioned on a third layer on the second layer. FIG. 18 may illustrate the first layer, second layer, third layer, and electrodes positioned on a fourth layer on the third layer.

First, referring to FIG. 15, the gate electrode 155, first gate electrode 255, second gate electrode 355, and first capacitor electrode 453 may be positioned at the first layer. The second gate electrode 355, first gate electrode 255, and first capacitor electrode 453 may be sequentially arranged along first direction D1. The gate electrode 155, the first gate electrode 255, the second gate electrode 355, and the first capacitor electrode 453 may be extended in second direction D2.

A separation pattern IP extending along the first direction D1 may be formed between the first amplification circuit AMP1 and the first high electron mobility transistor H1. The separation pattern IP may be formed before the gate electrode 155, first gate electrode 255, second gate electrode 355, and first capacitor electrode 453 are formed.

Referring to FIG. 16, a lower source electrode 173a, a lower drain electrode 175a, first and second source electrode 273 and 373, first and second drain electrode 275 and 375, and a conductive pattern 459 may be positioned at the second layer.

In one or more embodiments, the lower source electrode 173a and the second source electrode 373 may be formed integrally. The lower source electrode 173a may cover the gate electrode 155 positioned at the first layer and may serve as a field dispersing layer dispersing an electric field concentrated on the gate electrode 155. The second source electrode 373 and the second drain electrode 375 may be arranged to be spaced apart in the first direction D1, with the second gate electrode 355 interposed therebetween. The first source electrode 273 and the first drain electrode 275 may be arranged to be spaced apart in the first direction D1, with the first gate electrode 255 interposed therebetween. In one or more embodiments, the first source electrode 273 and the second drain electrode 375 may be formed integrally. The conductive pattern 459 may be positioned at a side of the first capacitor electrode 453.

In one or more embodiments, the lower source electrode 173a and the lower drain electrode 175a may extend along second direction D2. In one or more embodiments, the first and second source electrodes 273 and 373, the first and second drain electrodes 275 and 375, and conductive pattern 459 may extend along second direction D2.

The second drain electrode 375 and the first source electrode 273 may be electrically connected to the gate electrode 155 positioned at the first layer through the first contact hole CH1.

Referring to FIG. 17, the second capacitor electrode 457 may be positioned at the third layer. The second capacitor electrode 457 may be extended in the second direction D2. The second capacitor electrode 457 may have a region overlapping the first capacitor electrode 453 in a thickness direction. A width of the second capacitor electrode 457 along the first direction D1 may be smaller than a width of the first capacitor electrode 453 along the first direction D1. A width of the second capacitor electrode 457 along the second direction D2 may be substantially same as a width of the first capacitor electrode 453 along the second direction D2.

Referring to FIG. 18, the first and second power lines VL1 and VL2, the first and second signal lines GL1 and GL2, the upper source electrode 173b, and the upper drain electrode 175b may be positioned at the fourth layers.

The upper source electrode 173b may cover the lower source electrode 173a positioned at the second layer. The upper source electrode 173b may be electrically connected to the lower source electrode 173a positioned at the second layer through the ninth contact hole CH9. The upper drain electrode 175b may cover at least a portion of the lower drain electrode 175a positioned at the second layer. The upper drain electrode 175b may be electrically connected to the lower drain electrode 175a positioned at the second layer through the tenth contact hole CH10.

The first and second power lines VL1 and VL2, and the first and second signal lines GL1 and GL2 are arranged to be spaced apart in the second direction D2 and may extend along the first direction D1. The first power line VL1 may be connected to the first drain electrode 275 positioned at the second layer through the second contact hole CH2. The first power line VL1 may be connected to the first capacitor electrode 453 positioned at the first layer through the third contact hole CH3.

The second power line VL2 may be connected to the second source electrode 373 positioned at the second layer through the fourth contact hole CH4. The second power line VL2 may be connected to the second capacitor electrode 457 positioned at the third layer through the fifth contact hole CH5. The second power line VL2 may be connected to the conductive pattern 459 positioned at the second layer through the sixth contact hole CH6.

The first signal line GL1 may be connected to the first gate electrode 255 positioned at the first layer through the seventh contact hole CH7. The second signal line GL2 may be connected to the second gate electrode 355 positioned at the first layer through the eighth contact hole CH8.

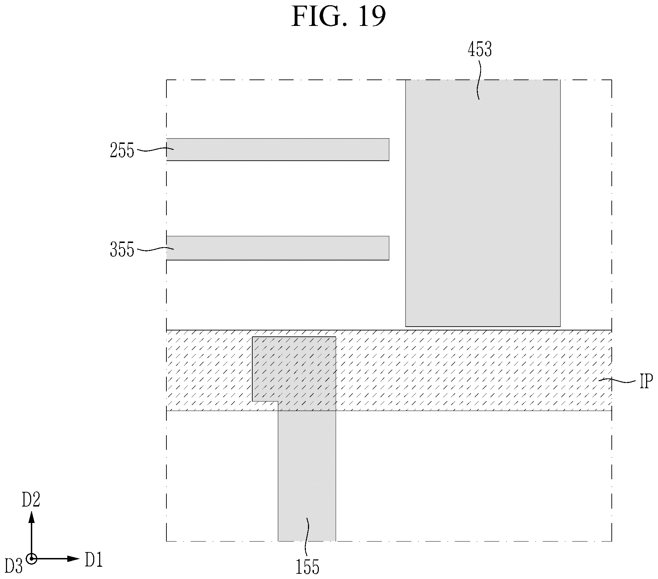

FIG. 19 to FIG. 23 are top plan views of a semiconductor device according to one or more embodiments. Specifically, FIG. 19 to FIG. 23 may be drawings illustrating that the electrodes 155, 173, and 175 of the first high electron mobility transistor H1 and the electrodes and conduction patterns (273, 275, 373, 375, 453, 457, 459, BP1) of the first amplification circuit AMP1 are sequentially overlapped according to the process order. Since many parts of the semiconductor device shown in FIG. 19 to FIG. 23 are the same as the semiconductor device described above, description for those will be omitted, and the differences will be mainly described below. The semiconductor devices shown in FIG. 19 to FIG. 23 may be different from the above described embodiment, in the direction in which the electrodes and conductive patterns 273, 275, 373, 375, 453, 457, 459 of the first amplification circuitAMP1 extend and in further including a bridge pattern BP formed in the fifth layer.

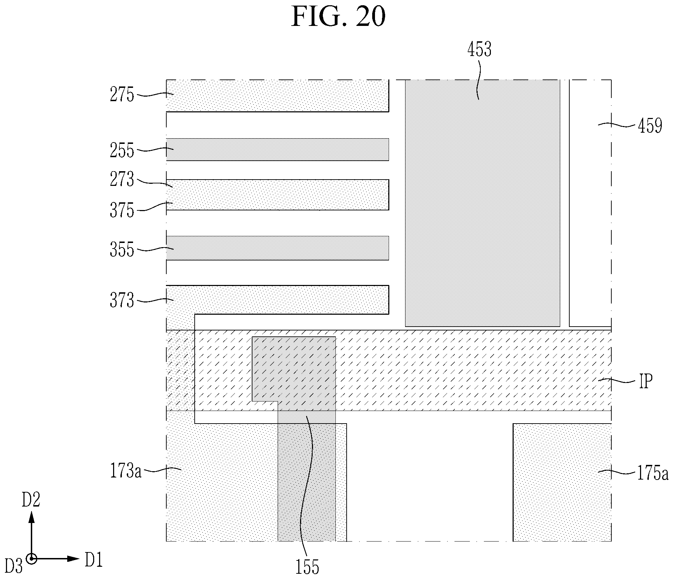

Referring to FIG. 19, the first gate electrode 255 and the second gate electrode 355 positioned at the first layer may be extended in the first direction D1. Referring to FIG. 20, the first and second source electrodes 273, and 373 and the first and second drain electrodes 275, and 375 positioned at the second layer may be extended in the first direction D1. That is, unlike the semiconductor device described with reference to FIG. 15 to FIG. 18, the first and second source electrodes 273 and 373, the first and second drain electrodes 275 and 375, and the first and second gate electrodes 255 and 355 of the semiconductor device according to the embodiment may be extended in the first direction D1.

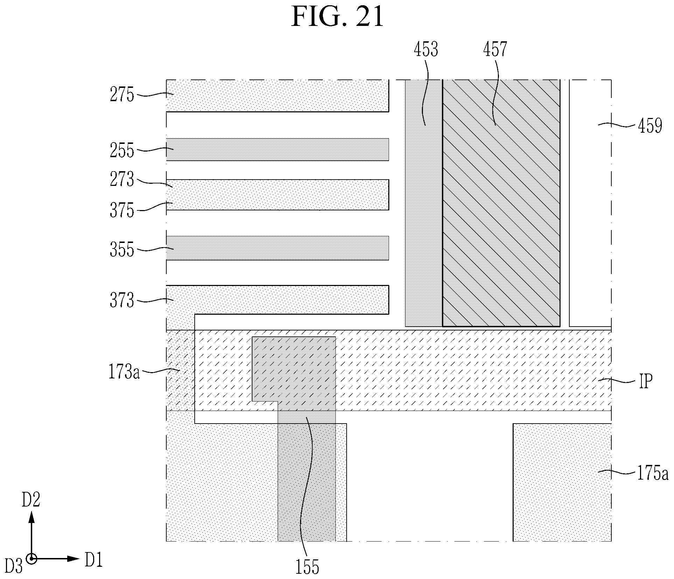

Referring to FIG. 21, the second capacitor electrode 457 overlapping the first capacitor electrode 453 in the third direction D3 may be positioned at the third layer,

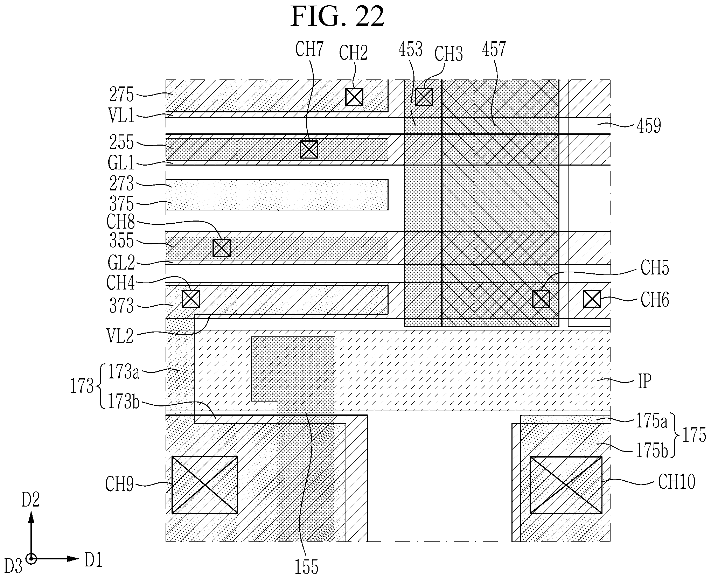

Referring to FIG. 22, the first and second power lines VL1 and VL2, the first and second signal lines GL1 and GL2, the upper source electrode 173b, and the upper drain electrode 175b may be positioned at the fourth layer.

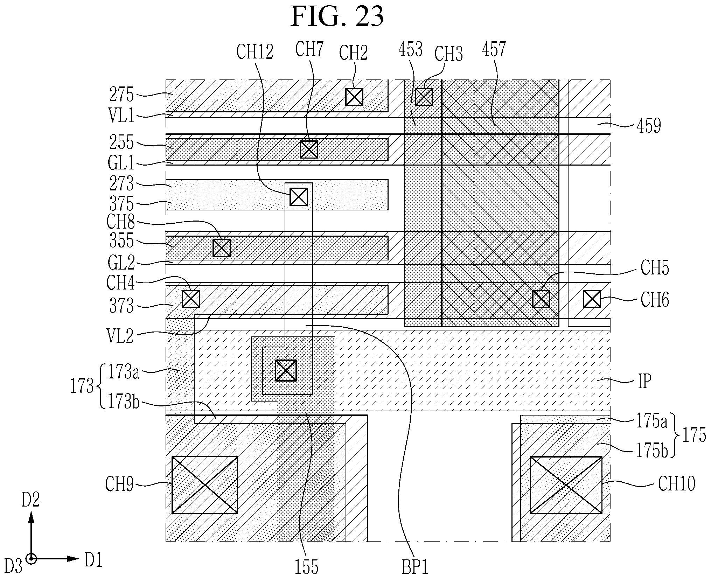

Referring to FIG. 23, the semiconductor device according to the embodiment may further include a first bridge pattern BP1 positioned at the fifth layer positioned on the fourth layer. The first bridge pattern BP1 may electrically connect the gate electrode 155 positioned at the first layer and the second drain electrode 375 positioned at the second layer. The first bridge pattern BP1 may be extended in the second direction D2. An end of the first bridge pattern BP1 may be connected to the gate electrode 155, and the other end of the first bridge pattern BP1 may be connected to the second drain electrode 375. The first bridge pattern BP1 may be connected to gate electrode 155 through the eleventh contact hole CH11 and to the second drain electrode 375 through the twelfth contact hole CH12.

In the case of the semiconductor device described with reference to FIG. 15 to FIG. 18, the gate electrode 155 and the second drain electrode 375 may be directly connected through the first contact hole CH1 (see Fig. 16) formed between the gate electrode 155 and the second drain electrode 375. On the other hand, in the case of a semiconductor device according to the present embodiment, the gate electrode 155 and the second drain electrode 375 may be electrically connected by the first bridge pattern BP1 separately formed at the fifth layer.

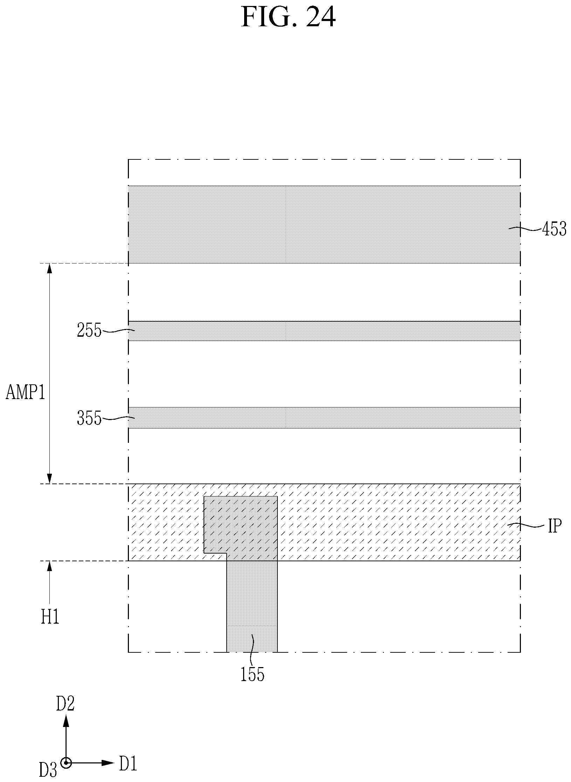

FIGS. 24 to 28 are top plan views of a semiconductor device according to one or more embodiments.

Specifically, FIG. 24 to FIG. 28 may be drawings illustrating that the electrodes 155, 173, and 175 of the first high electron mobility transistor H1 and the electrodes and conduction patterns (273, 275, 373, 375, 453, 457, 459, BP1, BP2) of the first amplification circuit AMP1 are sequentially overlapped according to the process order. Since many parts of the semiconductor device shown in FIG. 24 to FIG. 28 are the same as the semiconductor device described above, description for those will be omitted, and the differences will be mainly described below. The semiconductor device shown in FIG. 24 to FIG. 28 may be different from previous embodiments, in the position and connection relationship of the capacitor C1 and the conductive pattern 459 on a plan view and in further including a second bridge pattern BP2 formed at the fifth layer.

In one or more embodiments, the capacitor C1 may be positioned outside of the first amplification circuit AMP1 and the first high electron mobility transistor H1. Accordingly, the first capacitor electrode 453, the second capacitor electrode 457, and the conductive pattern 459 may be positioned outside the first amplification circuit AMP1 and the first high electron mobility transistor H1.

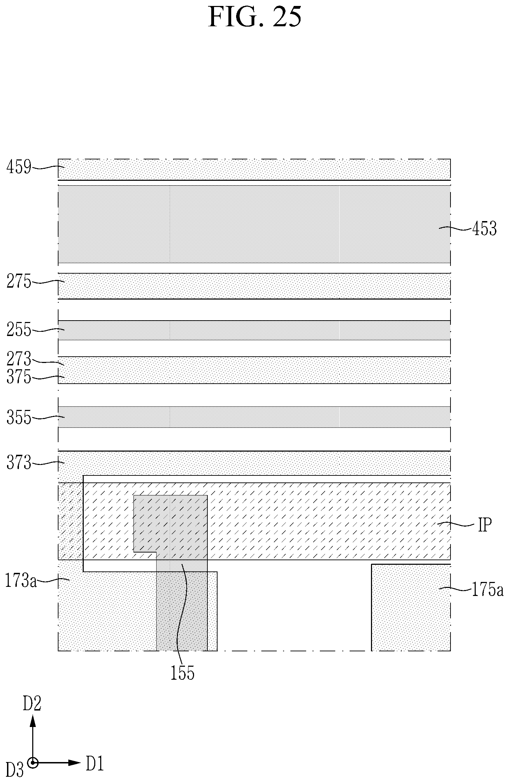

Referring to FIG. 24, the first capacitor electrode 453 may be formed spaced apart from the first amplification circuit AMP1 in the second direction D2. The first capacitor electrode 453 may be extended in the first direction. Referring to FIG. 25, the conductive pattern 459 can be positioned away from the first capacitor electrode 453 in the second direction D2. The conductive pattern 459 may be extended in the first direction D1.

In this embodiment, since the first capacitor electrode 453 and conductive pattern 459 are positioned outside of first amplification circuit AMP1, the first and second gate electrodes 255 and 355, first and second source electrodes 273 and 373, and first and second drain electrodes 275 and 375 may be extended further along the first direction D1, compared to the preceding embodiments. In other words, the length, which extend along the first direction D1, of the first and second gate electrodes 255 and 355, first and second source electrodes 273 and 373, and first and second drain electrodes 275 and 375 may be longer, compared to the above described embodiments.

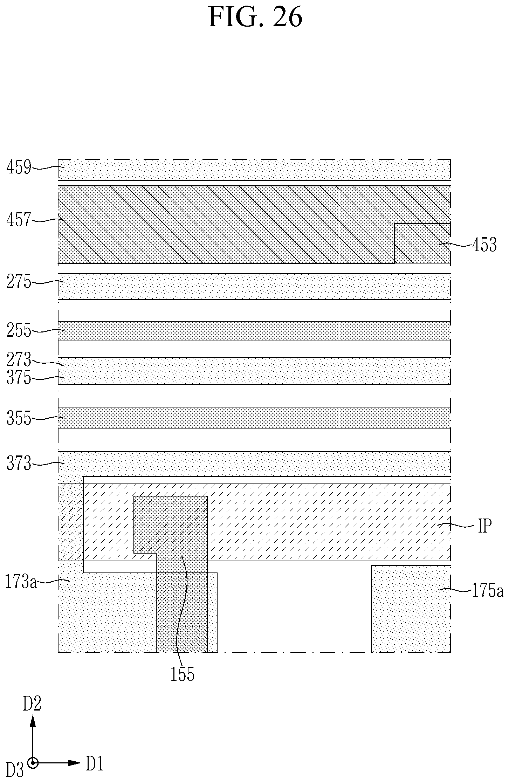

Referring to FIG. 26, the second capacitor electrode 457 positioned at the third layer may cover some regions of the first capacitor electrode 453. In one or more embodiments, the second capacitor electrode 457 may include a recess region in which some regions of the first capacitor electrode 453 positioned at the first layer is exposed. In the embodiment, the recess region may be positioned in a region adjacent to the first drain electrode 275 in the second direction D2. For example, referring to FIG. 26, the recess region may be positioned in a right corner region below the second capacitor electrode 457, when viewed from a plan view.

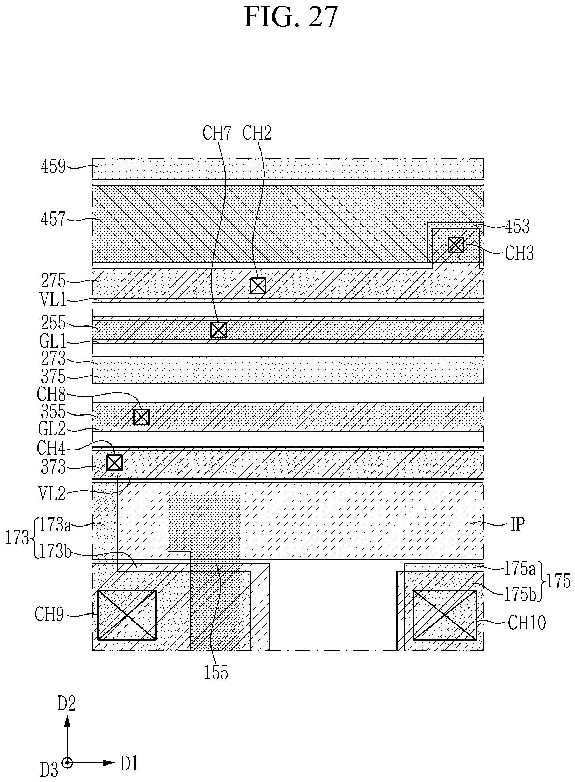

Referring to FIG. 27, the first power line VL1 positioned at the fourth layer extends in the first direction D1 and may include a region protruded in the second direction D2. The protruded region may overlap the recess region described with reference to FIG. 26 in the third direction D3. The first power line VL1 may be connected to the first capacitor electrode 453 by the third contact hole CH3 formed in the region overlapping the recess region in the third direction D3.

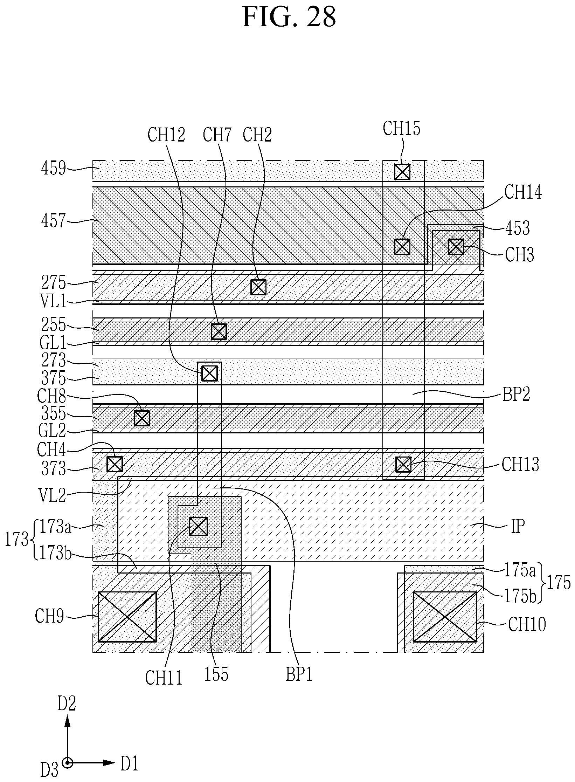

Referring to FIG. 28, the semiconductor device according to one or more embodiments may further include a second bridge pattern BP2 positioned at the fifth layer.

The second bridge pattern BP2 may electrically connect the second power line VL2 with the conductive pattern 459 positioned at the second layer and the second capacitor electrode 457 positioned at the third layer. The second bridge pattern BP2 can be extended in the second direction D2. The second bridge pattern BP2 may be commonly connected to the second power line VL2, conductive pattern 459, and second capacitor electrode 457. The second bridge pattern BP2 may be connected to the second power line VL2 through the thirteenth contact hole CH13, to the second capacitor electrode 457 through the fourteenth contact hole CH14, and to the conductive pattern 459 through the fifteenth contact hole CH15.

That is, in the embodiment, the conductive pattern 459 and the second capacitor electrode 457 may be electrically connected to the second power line VL2 by the second bridge pattern BP2 separately formed at the fifth layer.

While the disclosure has been particularly shown and described with reference to embodiments thereof, it will be understood that various changes in form and details may be made therein without departing from the scope of the following claims.

Embodiments are set out in the following clauses:
Clause 1: A semiconductor device comprising:
   a plurality of unit blocks comprising switching circuits, each of the switching circuits comprising:
   a high electron mobility transistor; and
   an amplification circuit configured to apply a gate signal to a gate electrode of the high electron mobility transistor; and
   a signal generator configured to provide a pull-up signal and a pull-down signal to the amplification circuit of each of the switching circuits,
   wherein high electron mobility transistors of the switching circuits are connected in parallel.
Clause 2: The semiconductor device of clause 1, wherein each of a plurality of amplification circuits comprises:
   a capacitor connected between a first power voltage and a second power voltage;
   a first transistor connected between the first power voltage and an output node configured to output the gate signal, the first transistor being configured to receive the pull-up signal; and
   a second transistor connected between the output node and the second power voltage and configured to receive the pull-down signal.
Clause 3: The semiconductor device of clause 2,
   wherein the high electron mobility transistor comprises:
   a channel layer;
   a barrier layer disposed on the channel layer;
   a gate electrode disposed on the barrier layer; and
   a source electrode and a drain electrode connected to the channel layer, and disposed on opposite sides of the gate electrode,
   wherein the first transistor comprises:
      a first channel layer spaced apart from the channel layer of the high electron mobility transistor;
      a first barrier layer disposed on the first channel layer;
      a first gate electrode disposed on the first barrier layer; and
      a first source electrode and a first drain electrode connected to the first channel layer, and disposed on opposite sides of the first gate electrode, and
      wherein the second transistor comprises:
         a second channel layer spaced apart from the channel layer of the high electron mobility transistor;
         a second barrier layer disposed on the second channel layer;
         a second gate electrode disposed on the second barrier layer; and
         a second source electrode and a second drain electrode connected to the second channel layer, and disposed on both sides of the second gate electrode.
Clause 4: The semiconductor device of clause 3, further comprising:
   a first power line configured to receive the first power voltage; and
   a first signal line configured to receive the pull-up signal,
   wherein the first gate electrode is connected to the first signal line,
   wherein the first source electrode is connected to the gate electrode of the high electron mobility transistor, and
   wherein the first drain electrode is connected to the first power line.
Clause 5: The semiconductor device of clause 4, further comprising:
   a second signal line configured to receive the pull-down signal; and
   a second power line configured to receive the second power voltage,
   wherein the second gate electrode is connected to the second signal line,
   wherein the second source electrode is connected to the second power line and the source electrode of the high electron mobility transistor, and
   wherein the second drain electrode is connected to the gate electrode of the high electron mobility transistor.
Clause 6: The semiconductor device of clause 5,
   wherein the source electrode and the drain electrode of the high electron mobility transistor are spaced apart in a first direction,
   wherein the gate electrode, the source electrode, and the drain electrode of the high electron mobility transistor extend along a second direction intersecting the first direction,
   wherein the first power line, the second power line, the first signal line, and the second signal line extend along the first direction and are spaced apart in the second direction, and
   wherein the first source electrode and the second drain electrode are integrated.
Clause 7: The semiconductor device of clause 6, wherein
   the first drain electrode, the first gate electrode, the first source electrode, the second gate electrode, and the second source electrode extend along the second direction and are spaced apart in the first direction.
Clause 8: The semiconductor device of clause 6, wherein
   the first drain electrode, the first gate electrode, the first source electrode, the second gate electrode, and the second source electrode extend along the first direction and are spaced apart in the second direction.
Clause 9: The semiconductor device of clause 8, wherein
   the capacitor is spaced apart from the first transistor and the second transistor in the first direction and overlaps the first power line, the second power line, the first signal line, and the second signal line in a third direction.
Clause 10: The semiconductor device of clause 8, wherein
   the capacitor is spaced apart from the first transistor and the second transistor in the second direction and does not overlap the first power line, the second power line, the first signal line, and the second signal line in a third direction.
Clause 11: The semiconductor device of any of clauses 3 to 10,
   wherein the first channel layer and the second channel layer are connected and disposed in a same layer as the channel layer of the high electron mobility transistor,
   wherein the first source electrode and the second source electrode are disposed in a same layer as the source electrode of the high electron mobility transistor, and
   wherein the first drain electrode and the second drain electrode are disposed in a same layer as the drain electrode of the high electron mobility transistor.
Clause 12: The semiconductor device of any of clauses 3 to 11, wherein the capacitor comprises:
   a first capacitor electrode connected to the first drain electrode;
   a first capacitor semiconductor pattern connected to the second source electrode, and overlapping the first capacitor electrode in a third direction; and
   a first dielectric material disposed between the first capacitor electrode and the capacitor semiconductor pattern.
Clause 13: The semiconductor device of clause 12,
   wherein the first capacitor electrode is disposed in a same layer as the gate electrode of the high electron mobility transistor,
   wherein the capacitor semiconductor pattern is disposed in a same layer as the channel layer of the high electron mobility transistor, and
   wherein the first dielectric material is disposed in a same layer as the barrier layer of the high electron mobility transistor.
Clause 14: The semiconductor device of clause 12 or 13, wherein the capacitor further comprises:
   a second capacitor electrode overlapping the first capacitor electrode in the third direction and connected to the second source electrode and the capacitor semiconductor pattern; and
   a second dielectric material disposed between the first capacitor electrode and the second capacitor electrode.
Clause 15: The semiconductor device of any of clauses 2 to 14,
   wherein the signal generator is configured to provide a protection signal to the plurality of amplification circuits, and
   wherein each of the plurality of amplification circuits further comprises a third transistor connected between the output node and the second power voltage and configured to receive the protection signal.

## Claims

1. A semiconductor device comprising a plurality of unit blocks comprising switching circuits, each of the switching circuits comprising:
a high electron mobility transistor; and
an amplification circuit configured to apply a gate signal to a gate electrode of the high electron mobility transistor,
wherein the amplification circuit of the each of the switching circuits being provided with a pull-up signal and a pull-down signal from a signal generator, and
wherein high electron mobility transistors of the switching circuits are connected in parallel.

2. The semiconductor device of claim 1, wherein each of a plurality of amplification circuits comprises:
a capacitor connected between a first power voltage and a second power voltage;
a first transistor connected between the first power voltage and an output node configured to output the gate signal, the first transistor being configured to receive the pull-up signal; and
a second transistor connected between the output node and the second power voltage and configured to receive the pull-down signal.

3. The semiconductor device of claim 2,
wherein the high electron mobility transistor comprises:
a channel layer;
a barrier layer disposed on the channel layer;
a gate electrode disposed on the barrier layer; and
a source electrode and a drain electrode connected to the channel layer, and disposed on opposite sides of the gate electrode,
wherein the first transistor comprises:
a first channel layer spaced apart from the channel layer of the high electron mobility transistor;
a first barrier layer disposed on the first channel layer;
a first gate electrode disposed on the first barrier layer; and
a first source electrode and a first drain electrode connected to the first channel layer, and disposed on opposite sides of the first gate electrode, and
wherein the second transistor comprises:
a second channel layer spaced apart from the channel layer of the high electron mobility transistor;
a second barrier layer disposed on the second channel layer;
a second gate electrode disposed on the second barrier layer; and
a second source electrode and a second drain electrode connected to the second channel layer, and disposed on both sides of the second gate electrode.

4. The semiconductor of claim 3, further comprising:
a first power line configured to receive the first power voltage; and
a first signal line configured to receive the pull-up signal,
wherein the first gate electrode is connected to the first signal line,
wherein the first source electrode is connected to the gate electrode of the high electron mobility transistor, and
wherein the first drain electrode is connected to the first power line.

5. The semiconductor of claim 4, further comprising:
a second signal line configured to receive the pull-down signal; and
a second power line configured to receive the second power voltage,
wherein the second gate electrode is connected to the second signal line,
wherein the second source electrode is connected to the second power line and the source electrode of the high electron mobility transistor, and
wherein the second drain electrode is connected to the gate electrode of the high electron mobility transistor.

6. The semiconductor device of claim 5,
wherein the source electrode and the drain electrode of the high electron mobility transistor are spaced apart in a first direction,
wherein the gate electrode, the source electrode, and the drain electrode of the high electron mobility transistor extend along a second direction intersecting the first direction,
wherein the first power line, the second power line, the first signal line, and the second signal line extend along the first direction and are spaced apart in the second direction, and
wherein the first source electrode and the second drain electrode are integrated.

7. The semiconductor device of claim 6, wherein
the first drain electrode, the first gate electrode, the first source electrode, the second gate electrode, and the second source electrode extend along the second direction and are spaced apart in the first direction.

8. The semiconductor device of claim 6, wherein
the first drain electrode, the first gate electrode, the first source electrode, the second gate electrode, and the second source electrode extend along the first direction and are spaced apart in the second direction.

9. The semiconductor device of claim 8, wherein
the capacitor is spaced apart from the first transistor and the second transistor in the first direction and overlaps the first power line, the second power line, the first signal line, and the second signal line in a third direction.

10. The semiconductor device of claim 8, wherein
the capacitor is spaced apart from the first transistor and the second transistor in the second direction and does not overlap the first power line, the second power line, the first signal line, and the second signal line in a third direction.

11. The semiconductor device of any of claims 3 to 10,
wherein the first channel layer and the second channel layer are connected and disposed in a same layer as the channel layer of the high electron mobility transistor,
wherein the first source electrode and the second source electrode are disposed in a same layer as the source electrode of the high electron mobility transistor, and
wherein the first drain electrode and the second drain electrode are disposed in a same layer as the drain electrode of the high electron mobility transistor.

12. The semiconductor device of any of claims 3 to 11, wherein the capacitor comprises:
a first capacitor electrode connected to the first drain electrode;
a first capacitor semiconductor pattern connected to the second source electrode, and overlapping the first capacitor electrode in a third direction; and
a first dielectric material disposed between the first capacitor electrode and the capacitor semiconductor pattern.

13. The semiconductor device of claim 12,
wherein the first capacitor electrode is disposed in a same layer as the gate electrode of the high electron mobility transistor,
wherein the capacitor semiconductor pattern is disposed in a same layer as the channel layer of the high electron mobility transistor, and
wherein the first dielectric material is disposed in a same layer as the barrier layer of the high electron mobility transistor.

14. The semiconductor device of claim 12 or 13, wherein the capacitor further comprises:
a second capacitor electrode overlapping the first capacitor electrode in the third direction and connected to the second source electrode and the capacitor semiconductor pattern; and
a second dielectric material disposed between the first capacitor electrode and the second capacitor electrode.

15. The semiconductor device of any of claims 2 to 14,
wherein each of the plurality of amplification circuits further comprises a third transistor connected between the output node and the second power voltage and configured to receive a protection signal provided by a signal generator.
